(19)

Europäisches
Patentamt
European
Patent Office
Office européen
des brevets

(11) **EP 4 113 625 A1**

(12) **EUROPEAN PATENT APPLICATION**

(43) Date of publication:
**04.01.2023 Bulletin 2023/01**

(21) Application number: **22181437.9**

(22) Date of filing: **28.06.2022**

(51) International Patent Classification (IPC):
**H01L 29/76** (2006.01)    **H01L 21/334** (2006.01)
**H01L 29/423** (2006.01)    **H01L 29/47** (2006.01)

(52) Cooperative Patent Classification (CPC):
**H01L 29/7606; H01L 29/423; H01L 29/66977;**
H01L 29/47

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **29.06.2021 US 202163216073 P**
**22.12.2021 US 202163292831 P**

(71) Applicant: **SolarEdge Technologies Ltd.**
**4673335 Herzeliya (IL)**

(72) Inventors:
• **HAVDALA, Tal**
**4673335 Herzeliya (IL)**
• **LEVI, Daniel**
**4673335 Herzeliya (IL)**
• **BEN-BASSAT, David**
**4673335 Herzeliya (IL)**
• **ZEHAVI, Matan**
**4673335 Herzeliya (IL)**
• **GOMBERG, Bryon Roos**
**4673335 Herzeliya (IL)**

(74) Representative: **V.O.**
**P.O. Box 87930**
**2508 DH Den Haag (NL)**

(54) **BARRIER MODULATING TRANSISTOR**

(57)     A transistor comprises a semiconductor substrate and a barrier metal layer forming a Schottky barrier. One or more insulated gates may be positioned adjacent to an edge of the Schottky barrier. By applying a reverse bias voltage between the semiconductor substrate and the barrier metal, and applying a gate voltage between the one or more insulated gates and the barrier metal, a reverse bias current may be increased to a reverse bias conducting state. When the gate voltage is sufficient, the transistor may conduct current between the semiconductor substrate and the barrier metal. For example, voltages may be applied to an n-type substrate and an insulated gate (both relative to the barrier metal), and a current may flow from the semiconductor substrate to the barrier metal. The transistor may operate as a switch, a filter, a rectifier, an oscillator, or an amplifier.

FIG. 1A

EP 4 113 625 A1

**Description**

**CROSS-REFERENCE TO RELATED APPLICATIONS**

This application claims the benefit of U.S. Provisional Application No. 63/216,073, filed on June 29, 2021 and the benefit of U.S. Provisional Application No. 63/292,831, filed on December 22, 2021. The above-referenced applications are hereby incorporated by references in their entireties.

**BACKGROUND**

The present disclosure relates to the field of electronics.

Transistors may be used in electronic devices and may change the current and/or voltage of two terminals of the transistor between a first resistance state and a second resistance state, in response to a voltage or current on a second pair of terminals. For example, a transistor connects (such as by short circuit) or disconnects (such as by open circuit) one conductor terminal from another. A transistor may be used as a switch to turn a conduction path on or off (substantially shorted or substantially open circuit, respectively). The transistor may be used as an amplifier where a low power signal may generate a high power signal (amplify the signal).

The transistor used as a switch operates between an "on" state and an "off state. The resistance of the transistor in the "on" state is low, or near zero (short circuit), and the resistance in the "off" state is high, or effectively an open circuit. For example, when the transistor is in the "on" state, a current may flow between two of the transistor's terminals. The mechanisms for switching between the two states may use solid-state electronics configured to change two of the transistor terminals between the two states based on a control signal applied between a control terminal and one of the other terminals (or another terminal). The transistor may comprise basic physical semiconductor units dependent on a particular semiconductor fabrication process, and the transistor may be configured in a variety of ways depending on the specific configuration of materials (such as, but not limited to, insulating materials, semiconductor materials, and metals) used to convert the control signal to the output voltage and current between the two other terminals. For example, the two other terminals are an electron emitter terminal and an electron collector terminal. For example, the two other terminals are an electron source terminal, and an electron drain terminal. For example, the two other terminals are a cathode and an anode.

**SUMMARY**

The following summary is a short summary of certain features. The summary is not an extensive overview and is not intended to identify key or critical elements

Disclosed herein are techniques and devices to switch a conductivity state of between two terminals of a transistor when a voltage is applied to a gate electrode, such as a control terminal of a transistor. For example, the drain and source may be an n-type semiconductor substrate (or "substrate" as used herein) and a contacting barrier metal layer respectively, thereby forming an n-type Schottky barrier (SB). For example, the drain and source may be a barrier metal layer and a p-type semiconductor substrate respectively, thereby forming a p-type SB. The semiconductor substrate may be an n-type or p-type semiconductor material, and the contact between the semiconductor substrate and the barrier metal layer may form a metal-semiconductor contact region. The periphery of the metal-semiconductor contact region comprises a barrier edge, such that the edge surrounds the metal-semiconductor contact region. The "edge effect" of an SB is the leakage of current of the SB when forward voltage is applied to the SB. Similarly, the edge comprises the locations of highest charge density of the barrier metal layer when a reverse bias voltage is applied.

As used herein, the terms source and drain will be used for the two terminals, and gate for the control terminal, but it is understood that this is equivalent to other naming conventions. For example, other naming conventions may be emitter, collector, and base. For example, other naming conventions may be anode, cathode, and gate.

A conducting gate electrode may be positioned near the edge of the barrier metal layer ("metal" or "metal layer" as used herein), and may be insulated from the edge and insulated from the semiconductor substrate ("semiconductor material" as used herein), thereby producing an insulated gate electrode. One or more conducting gate electrodes may be positioned near the edge of the barrier metal layer, and as used herein the term "gate electrode" may mean more than one physical gate electrode, such as a plurality of gate electrodes near a plurality of barrier metal edges. When a gate voltage relative to the metal voltage (in the same direction as the reverse bias voltage) is applied to the insulated gate electrode (concurrent with a reverse bias voltage applied between the semiconductor and the metal, which may be assumed for the following examples), an electric field may be created between the insulated gate electrode and the metal. A gate voltage is a voltage on the gate electrode that has a value between the voltage of the barrier metal ("metal voltage" as used herein) and the voltage of the semiconductor substrate, or a voltage closer to the semiconductor substrate voltage than the barrier metal voltage. The gate electrode, when charged to a gate voltage relative to the barrier metal voltage, may increase the edge effect and the charge density at the edge of the barrier metal. The gate electrode, when charged to a gate voltage relative to the metal voltage, may modulate the Schottky energy barrier. The gate electrode, when charged to a gate voltage relative to the metal voltage, may increase the thermionic emission at the edge of the metal layer. The gate electrode, when charged to a gate voltage relative to the metal voltage, may increase the thermionic field emission at the edge of the metal layer. The gate electrode, when charged to a suitable voltage relative to the metal voltage, may increase the tunneling current at the edge of the metal layer.

When the gate electrode is activated, such as when a voltage relative to the metal voltage is applied to the gate electrode, and the reverse bias voltage applied between the metal layer and the semiconductor substrate, a substantial reverse bias current may flow across the Schottky barrier. Similarly, when a reverse gate voltage is applied to the gate electrode (relative to the metal voltage), the reverse bias leakage current may be lowered or substantially eliminated. A reverse gate voltage may be a voltage value that is not between the metal voltage and the semiconductor substrate voltage, and is closer to the metal voltage than the semiconductor substrate voltage, such as the voltage of an ohmic contact of the semiconductor substrate. When a reverse gate voltage is applied to the gate electrode (relative to the metal voltage), the voltage threshold for forward Schottky current may be lowered and the forward current for a given voltage may be increased. A shape and/or position of the gate electrodes relative to the edge of the metal-semiconductor contact region and the voltage profiles applied to the gate electrodes may determine effective leakage current that may be produced.

Examples herein relate to a device comprising an n-type semiconductor substrate when not specifically directed to a p-type semiconductor substrate. For example, when the semiconductor substrate is n-type, a high gate electrode voltage relative to the metal voltage may increase the electron density at the edges of the metal layer and may increase the reverse bias current flow between the semiconductor substrate and the metal. For example, when the semiconductor substrate is p-type, a low gate electrode voltage relative to the metal voltage may increase the hole density at the edges of the metal layer and may increase the reverse bias current flow between the metal and the semiconductor substrate.

## BRIEF DESCRIPTION OF THE DRAWINGS

These and other features and advantages are described in greater detail below. Some features are shown by way of example, and not by limitation, in the accompanying drawings. In the drawings, like numerals reference similar elements.

FIG. 1A shows an example of a cross-section-view of a barrier modulating (BM) transistor having reverse bias current enhancing electrodes.

FIG. 1B shows an example of an enlarged partial view of FIG. 1A.

FIG. 2 shows an example flowchart for activating current flow in the reverse bias direction of a BM transistor.

FIG. 3A shows an example of a top-view of a BM transistor with comb-like structures.

FIG. 3B shows an example of a top-view of a BM transistor with circular perforations.

FIG. 3C shows an example of a top-view of a BM transistor with rectangular perforations.

FIG. 3D shows an example of a top-view of a BM transistor with circular interconnected metal layers and surrounding reverse bias current enhancing electrodes.

FIG. 3E shows an example of an enlarged partial view of FIG. 3D.

FIG. 4 shows an example of a renewable power generation system using BM transistors.

FIG. 5A shows an example of a cross-section-view of a BM transistor with reverse bias current enhancing whisker gate electrode on the semiconductor substrate.

FIG. 5B shows an example of a cross-section view of a BM transistor with singular Schottky structures and a reverse bias current enhancing electrode grid.

FIG. 6A shows an example of a cross-section view of a BM transistor with reverse bias current enhancing electrode near the metal edges.

FIG. 6B shows an example of a cross-section view of a BM transistor with reverse bias current enhancing electrode over the barrier metal.

FIG. 6C shows an example of a cross-section view of a BM transistor with reverse bias current enhancing electrode with an air gap.

FIG. 6D shows an example of a cross-section view of a BM transistor with reverse bias current enhancing whisker electrode and two insulating layers.

FIG. 6E shows an example of a cross-section view of a BM transistor with reverse bias current enhancing electrode over the edges of the barrier metal.

FIG. 6F shows an example of a cross-section view of a BM transistor with reverse bias current enhancing whisker electrode and two insulating layers.

FIG. 7A shows an example microscopic image of a top view of a BM transistor with a 32 element comb-like structure.

FIG. 7B shows an example microscopic image of a top view of a BM transistor with a 20 element comb-like structure.

FIG. 7C shows an example graph of current density versus Vds of a BM transistor.

FIG. 7D shows an example graph of current versus Vds of a BM transistor.

FIG. 7E shows example maps of simulation results of the BM transistor of FIG. 6B.

FIG. 8A shows a flowchart of an example method of manufacturing a BM transistor using a single mask.

FIG. 8B shows an example of a cross-section view of a wafer for manufacturing a BM transistor.

FIG. 8C shows an example of a cross-section view of a photoresist applied on a wafer for manufacturing a BM transistor.

FIG. 8D shows an example of a cross-section view of an etched metal of a wafer for manufacturing a BM transistor.

FIG. 8E shows an example of a cross-section view of an etched dielectric of a wafer for manufacturing a BM transistor.

FIG. 8F shows an example of a cross-section view of an undercut dielectric of a wafer for manufacturing a BM transistor.

FIG. 8G shows an example of a cross-section view of a wafer with deposited barrier metal for manufacturing a BM transistor.

FIG. 8H shows an example of a cross-section view of a wafer with an undercut and deposited barrier metal for manufacturing a BM transistor.

FIG. 9 shows an example of cross-section views of example shapes for undercuts of a BM transistor.

FIG. 10A shows a flowchart of an example method of manufacturing a BM transistor using a single mask.

FIG. 10B shows an example of a cross-section view of a wafer for manufacturing a BM transistor.

FIG. 10C shows an example of a cross-section view of a photoresist applied on a wafer for manufacturing a BM transistor.

FIG. 10D shows an example of a cross-section view of an etched metal of a wafer for manufacturing a BM transistor.

FIG. 10E shows an example of a cross-section view of an applied dielectric layer on a wafer for manufacturing a BM transistor.

FIG. 10F shows an example of a cross-section view of an applied gate metal layer on a wafer for manufacturing a BM transistor.

FIG. 10G shows an alternative flowchart of the method of FIG. 10A of manufacturing a BM transistor using two masks.

FIG. 10H shows an example of a cross-section view of a photoresist and etch applied to a wafer for manufacturing a BM transistor.

FIG. 10I shows an example of a cross-section view of an applied dielectric layer on a wafer for manufacturing a BM transistor.

FIG. 10J shows an example of a cross-section view of an applied gate metal layer on a wafer for manufacturing a BM transistor.

FIG. 10K shows an example of a cross-section view of a second photoresist and etch applied to a wafer for manufacturing a BM transistor

FIG. 11A shows a flowchart of an example method of manufacturing a BM transistor using two masks.

FIG. 11B shows an example of a cross-section view of a wafer for manufacturing a BM transistor.

FIG. 11C shows an example of a cross-section view of a photoresist applied on a wafer for manufacturing a BM transistor.

FIG. 11D shows an example of a cross-section view of an etched dielectric on a wafer for manufacturing a BM transistor.

FIG. 11E shows an example of a cross-section view of an applied metal layer on a wafer for manufacturing a BM transistor.

FIG. 11F shows an example of a cross-section view of a second photoresist applied on a wafer for manufacturing a BM transistor.

FIG. 11G shows an example of a cross-section view of an etched metal on a wafer for manufacturing a BM transistor.

FIG. 11H shows an example of a cross-section view of the second mask removed from a wafer for manufacturing a BM transistor.

FIG. 12A shows a flowchart of an example method of manufacturing a BM transistor using two masks.

FIG. 12B shows an example of a cross-section view of a wafer for manufacturing a BM transistor.

FIG. 12C shows an example of a cross-section view of a photoresist applied on a wafer for manufacturing a BM transistor.

FIG. 12D shows an example of a cross-section view of an etched epi layer of a wafer for manufacturing a BM transistor.

FIG. 12E shows an example of a cross-section view of an applied dielectric and metal layer on a wafer for manufacturing a BM transistor.

FIG. 12F shows an example of a cross-section view of a second photoresist and metal layer applied on a wafer for manufacturing a BM transistor.

FIG. 12G shows an example of a cross-section view of a liftoff of the second photoresist of a wafer for manufacturing a BM transistor.

**DETAILED DESCRIPTION**

The accompanying drawings, which form a part hereof, show examples of the disclosure. It is to be understood that the examples shown in the drawings and/or discussed herein are non-exclusive and that there are other examples of how the disclosure may be practiced.

Disclosed herein are examples of devices, methods, and systems that may be used for implementing a transistor including a reverse bias current enhancing insulated gate electrode located near an edge of a Schottky barrier (SB). For example, a Schottky barrier may be created at the interface between a semiconductor and a metal layer (also referred to as the "metal"). The contact region between the semiconductor and the metal may create an SB. The edge of the metal (at the periphery of the metal conductive contact region) may include a convex curvature of particular radius and enhanced charge density. A reverse bias current enhancing electrode (also referred to as a "gate electrode") may be located near the edge of the Schottky barrier and a voltage applied to the insulated gate electrode may increase the reverse bias current and increase the charge density at the edge of the SB. When a voltage is applied to the reverse bias current enhancing electrode, the barrier of the SB may be modulated, such as changed in size, shape, height, width, etc. According to the Pauli Exclusion Principle, an increase in charge density may force electrons to populate increasingly higher energy levels. The gate electrode voltage may lower the barrier height. The gate electrode voltage may decrease the barrier width. The gate electrode voltage may increase a tunneling probability. The gate electrode voltage may increase thermionic emission.

The placement and shape of the gate electrode may be configured to increase reverse leakage current between the semiconductor and the metal when a voltage is applied to the gate electrode, relative to the metal. For example, when an n-type semiconductor is used, and a positive voltage is applied to the gate electrode (relative to the metal), the reverse bias current from the semiconductor to the metal may be increased by one or more orders of magnitude. The choice of metal type and semiconductor type may determine the Fermi energy levels that limit and define the Schottky barrier characteristics. Similarly to using an n-type semiconductor, a p-type semiconductor may be used but with a negative voltage applied to the gate electrode relative to the metal layer, and the reverse bias current may be from the metal to the semiconductor. The term Barrier Modulating (BM) transistor may refer herein to a transistor with an insulated gate electrode near a Schottky barrier edge, which may increase the reverse bias current across the Schottky barrier. The BM transistor may be used as a switch to connect or disconnect components of a circuit, such as when the BM transistor is saturated on or off. The BM transistor may be used as an amplifier where a voltage control signal on the gate electrode may be converted to a current signal between the source and drain (where the input power may be less than the output power), such as when the BM transistor is operated in linear mode. The BM transistor may operate as a switch, filter, rectifier, oscillator, or amplifier.

Although some examples of n-type semiconductor material may be given, similar examples may be disclosed using p-type semiconductor material and appropriate changes to materials, configurations, and methods of operation. The choice of materials (e.g., using n-type semiconductor material, p-type semiconductor, material, metal, etc.) may be based on a configuration that enables a high transistor gain or a high leakage current under reverse bias conditions due to an applied gate electrode voltage. A gate electrode voltage may be high or low relative to a metal layer, depending on the semiconductor type (n-type or p-type). When the gate voltage is applied to the gate electrode, a current may flow in a reverse bias direction (from n-type semiconductor to metal or from metal to p-type semiconductor respectively).

As used herein the term "gate", "gate electrode", or "reverse bias current enhancing electrode" may be used interchangeably to mean a gate electrode conductor near the edges of the barrier metal layer for enhancing a reverse bias current and charge density at the edges of a barrier metal layer when a voltage is applied to the gate electrode relative to the barrier metal. As used herein, the terms "insulated gate" or "insulated electrode" may be used interchangeably to mean a gate electrode and an insulating dielectric layer between the gate electrode and the semiconductor substrate and between the gate electrode and the barrier metal.

The term transistor may be used herein to mean an electrical device that, based on a control signal applied to a control terminal of the transistor (relative to another terminal of the transistor), controls an electrical connection between a first contact terminal of the transistor to a second contact terminal of the transistor. For example, when a voltage or current is applied to the control terminal (such as the gate electrode of a transistor), the effective resistance between the first contact terminal (e.g., source of the transistor) and the second contact terminal (e.g., drain of the transistor) may change from a substantial open circuit to a substantial short circuit (within the limits of the connecting technology of the transistor). For the sake of brevity, the terms gate, source, or drain may be used herein to refer to the control terminal, first contact terminal, or second contact terminal, respectively, of a transistor depending on the transistor type: n-type or p-type.

Transistors may be configured for low power electronics, such as computers, smartphones, tablets, or the like, and these typically use transistors rated up to 20 volts (V) and 2 amperes (A). Power transistors, such as used in power converters, inverters, etc., may use one or more transistors rated above 20V (such as up to 2,000 V) and above 1 ampere (such as up to 1,000 A). Many transistors, for either low or high power applications (or both), may be configured from basic units of physical transistors determined by the semiconductor device fabrication process. The basic units may be sized, shaped, or arranged (such as in parallel and serial configurations) to reach the rated voltages and currents used for each type of transistors. The materials used for the transistor components, such as the materials used for the source, drain, or gate electrode, determine the basic electrical ratings under with the transistor may reliably operate.

The different configurations of semiconductor materials, metal materials, or insulating materials may determine the method of operation of the transistors. For example, transistors may include many types of transistors, such as metal-oxide-semiconductor field-effect transistors (MOSFETs), bipolar junction transistors (BJTs), insulated-gate bipolar transistor (IGBT), etc. Each type of transistor may have certain benefits for specific applications. For example, transistors may be used to alternatively connect or disconnect a power input terminal of a switch-mode power supply (SMPS) to a power conversion circuit. For example, in a specific topology of an SMPS, one or more transistors may be turned on to connect the power input terminal to an electrical energy storage device, and when the transistors may be turned off (disconnected), the stored energy may be converted to an alternative state, for example, a different voltage and/or current. In some cases, the transistor may be connected directly to a load or different component not having storage capabilities.

When a tunneling mechanism is dominant, a reverse leakage current of a SB may be expressed by the equation:

$$J_{TUN} = \frac{A^*T}{k_B} \int_{\varepsilon_B}^{E_{Fm}+\phi_B} \Gamma(\varepsilon') \ln\left[\frac{1+\exp(-(\varepsilon'-E_{Fm})/k_BT)}{1+\exp(-(\varepsilon'-E_{Fs})/k_BT)}\right] d\varepsilon'$$

Where $A^*$ denotes the Richardson constant, T denotes the temperature, $E_{FS}$ denotes the quasi-Fermi level for the semiconductor, $E_{Fm}$ denotes the Fermi level for the metal, $\phi_B$ denotes the Schottky barrier height (SBH), $\varepsilon_B$ denotes the origin of the energy of the free electron in the metal, and $\Gamma(\varepsilon')$ denotes the tunneling probability. The choice of metal and semiconductor materials may affect $E_{Fm}$ and $E_{Fs}$, as well as $\Gamma(\varepsilon')$ and $\phi_B$. The parameters (such as gate position, size, shape, voltage difference to metal, or the like) of an insulated gate described herein may be configured to affect $\varepsilon_B$, $\Gamma(\varepsilon')$ and $\phi_B$.

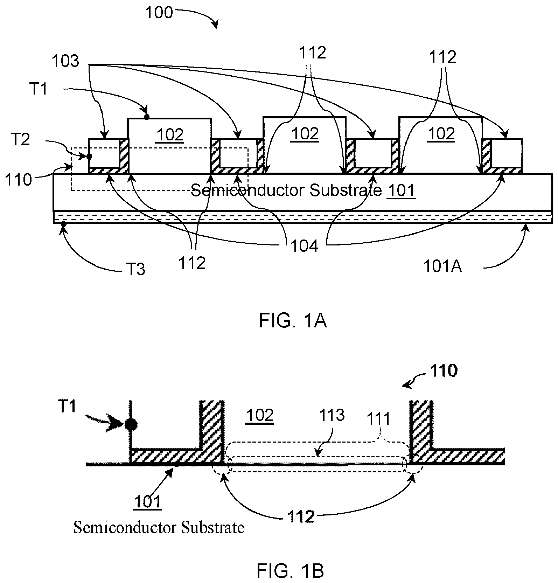

FIG. 1A shows an example of a cross-section-view of a barrier modulating (BM) transistor having reverse bias current enhancing electrodes. The reverse bias current enhancing electrodes may be gate electrodes. FIG. 1B shows an example of an enlarged partial view of FIG. 1A. For example, a BM transistor 100 may have gate electrodes 103 (e.g., reverse bias current enhancing gate electrodes). The enlarged partial view 110 shows the gate electrodes 103. A semiconductor substrate 101 may have an ohmic contact 101A. The semiconductor substrate 101 may be deposited with a metal layer 102 applied on to the semiconductor substrate 101 to form a Schottky barrier 111 between the semiconductor substrate 101 and the metal layer 102. The SB may be formed with the appropriately configured selection of semiconductor type and metal types, for example an n-type silicon semiconductor substrate (such as doped with Boron) and a platinum metal. The Schottky barrier 111 may comprise edges 112 and non-edges 113. The gate electrodes 103 may be placed near the edges 112, for example to enhance the charge density at the edges 112 of the Schottky barrier. The gate electrodes 103 may be insulated from the metal layer 102 and semiconductor substrate 101 using an insulating layer 104 that may act as a dielectric and may have a high electric field breakdown strength. The electric field breakdown voltage of the insulating layer 104 may vary depending on the distance from the edges 112, the geometry of the barrier metal and gate electrode, and the insulating materials between the gate electrode, the barrier metal, and the semiconductor substrate. For example, by employing combinations of different insulating dielectric materials in the insulating layer 104. For example, a region of the insulating layer 104 located between the edges 112 and the gate electrodes 103 may include a material with both a high dielectric constant and a high breakdown strength. For example, the multiplication of the dielectric constant and the breakdown strength of the material is high relative to other dielectric materials. In some cases, the selection of the dielectric material may be determined by the compatibility of the material with the manufacturing process, the substrate material, the gate electrode material, and the barrier metal material. For example, the insulating dielectric material may be selected to provide a compatible interface with the other materials. In regions located further from the edges 112, the insulating layer 104 may have a low dielectric constant, which may assist in further increasing the charge density at the edges 112. For example, in the BM transistor 100, a terminal T3 may be electrically connected to the ohmic contact 101A, a terminal T1 may be electrically connected to the metal layer 102, and a Vds voltage (for example, a drain-source voltage) may exist between terminal T1 and terminal T3.

The choice of insulating materials may be based on the dielectric constant, the breakdown strength, the combination of a high dielectric constant and a high breakdown strength, the multiplication of the dielectric constant and the breakdown strength, the electrode geometry, or the manufacturing process. For example, a first manufacturing process may favor using a hafnium dioxide insulating material, and a second manufacturing process may favor using an alumina insulating material. For example, a material with both a high dielectric constant and a high breakdown strength may be preferable over a second material with an extremely high dielectric constant and a low breakdown strength, despite the second material having a higher multiplication of the two values.

The choices of substrate material, doping elements, ohmic contacts metals, Schottky barrier metals, and gate electrode metals may be selected based on the BM transistor design. For example, the design may call for a type of semiconductor (n-type or p-type), and the resulting operational parameters and device properties (Rdson, Vdson, etc.) of available materials and metals at a particular semiconductor foundry where the BM transistor is being built. For example a particular wafer production line may comprise Si substrates, Boron dopants for n-type semiconductor doping, and Pt for SB metal, Au for gate electrode, and Ti for ohmic contact.

Following is TABLE 1 listing example materials that may be used for substrate materials, barrier metals, and ohmic contact metals. Ohmic contacts are dependent on specific metals, substrates, thermal processing, multi-layering, temperature, and other manufacturing parameters. For example, nickel may be used as a barrier metal and an ohmic contact, and thermal treatment may determine the type of interface that is produced. This is a list of some of the materials known to produce Schottky barriers when attached to the respective substrates, and it is not a limiting list of examples. For example, new materials and/or manufacturing processes may be developed that may be used to produce a BM transistor.

TABLE 1: example materials for substrate, barrier metal, and ohmic contact metals.

| Substrate materials (n-type and p-type) | Barrier metals | Ohmic contact metals |
|---|---|---|
| Si | Platinum, iron, nickel, cadmium, tin, lead, antimony, bismuth, manganese, gold, cobalt, palladium, aluminum, molybdenum, chromium, rhodium, rhenium, | Titanium, aluminum, silver, platinum, platinum silicide, titanium silicide, nickel |
| SiC | Platinum, iridium, gold, nickel, molybdenum, tungsten, titanium, and nickel-silicide, palladium-gold | Titanium, aluminum, silver, nickel, titanium silicide, titanium carbide, tantalum, tantalum carbide, nickel-silicide, palladium |
| GaN | Nickel, platinum, gold, cobalt, palladium, molybdenum, chromium, rhodium, rhenium, platinum silicide, and nickel silicide | Titanium, aluminum, silver |

Following is TABLE 2 that lists example elements that may be used for doping. This is a list of some of the elements known to dope the respective substrates, and it is not a limiting list of examples. For example, new materials and/or manufacturing processes may be developed that may be used to produce a BM transistor.

TABLE 2: example substrate materials and example dopants.

| Substrate material | P-type dopant | N-type dopant |
|---|---|---|
| Si | Boron, Aluminum, Gallium, Indium | Phosphorus, Arsenic, Antimony, Bismuth, Lithium |
| SiC | Aluminum, Boron | Nitrogen, Phosphorus |
| GaN | Magnesium | Silicon, Germanium, Carbon |

The elements that may be used for gate electrode metal are aluminum, copper, titanium, iron, silver, and gold.

For example, when the semiconductor substrate 101 is n-type, applying a positive Vds voltage comprises raising the voltage of terminal T3 relative to terminal T1. For the n-type semiconductor substrate, the terminal T1 (connected to the metal layer 102) may be a source and the terminal T3 ( connected to the semiconductor substrate 101) may be a drain. Similarly, a terminal T2 may be electrically connected to at least one of the gate electrodes 103 and may be used to enable a positive voltage (Vgs) between a gate (such as at least one of gate electrodes 103) and the source (such as metal layer 102). For example, applying a positive Vgs voltage comprises raising a voltage of terminal T2 relative to terminal T1, thereby causing a current flow between the terminal T3 and the terminal T1 (or electrons that flow from a source, as at terminal T1, to a drain, as at terminal T3) or causing the voltage of the terminal T3 to be effectively equivalent to a voltage of the terminal T1 (short circuit such as near zero resistance).

Similar examples may be disclosed using a p-type semiconductor, where current may flow from terminal T1 to terminal T3 when a negative voltage is applied to terminal T2 (relative to terminal T1). The terminals T1, T2, and T3 may be isolated. For the p-type semiconductor substrate, the terminal T1 (connected to the metal layer 102) may be a drain and the terminal T3 (connected to the semiconductor substrate 101) may be a source. For example when the semiconductor substrate 101 is p-type, applying a negative Vds voltage may comprise lowering the voltage of terminal T3 relative to terminal T1. Similarly, the terminal T2 may be electrically connected to at least one of the gate electrodes 103 and thereby produce a negative voltage (Vgd) between a gate (such as at least one of gate electrodes 103) and a drain (such as the metal layer 102). For example, applying a negative Vgd voltage may comprise lowering the voltage of terminal T2 relative to terminal T1, which may cause a current to flow between terminal T1 and terminal T3 (or electrons that flow from a source, as at terminal T3, to a drain, as at terminal T1) or cause the voltage of terminal T3 to be equivalent to terminal T1 (such as a short circuit or near zero resistance).

A material having a high dielectric constant and having a high electric field breakdown strength as the insulating layer 104 between the gate electrodes 103 and the metal layer 102 may be configured to produce a high electrical field near the SB edge 112. This may increase the charge density on the SB edge 112, especially when the material is used between the SB edge 112 and the gate electrode 103. As used herein, the term "high-K dielectric material" or "high-K material" mean a material with a dielectric constant greater than 3.5 and a dielectric breakdown strength greater than 10 kilovolt per centimeter (kV/cm). For example, using a high-K dielectric material may allow a very small insulating layer thickness, thereby increasing the gate capacitance and decreasing the gate switching response time. Materials that may be used for an insulating layer may include silica, alumina, or other insulting materials.

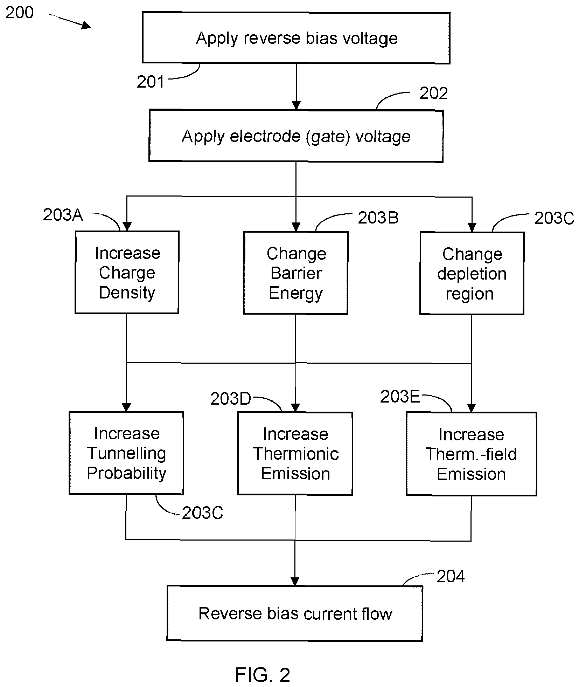

Reference is now made to FIG. 2, which shows a flowchart 200 of a method for activating tunneling in the reverse bias direction of a Schottky barrier in a BM transistor. At step 201, a control device (via a voltage driver) may apply a reverse bias voltage to the Schottky barrier, such as for an n-type semiconductor applying a high voltage to terminal T3 and a low voltage to terminal T1. At Step 202, the controller may apply a high voltage to terminal T2 relative to terminal T1 (Vgs). The high voltage of the gate electrode 103 relative to the metal layer 102 may affect the edges 112 (corners) of the metal layer 102. The contact between the metal layer 102 and the semiconductor substrate 101 may be the SB.

In the example of a p-type semiconductor substrate, at step 201 a reverse bias voltage may be applied to the Schottky barrier may comprise applying a low voltage to T3 and a high voltage to terminal T1. At Step 202 a low voltage may be applied to terminal T2 relative to terminal T1 (Vgd). The low voltage of the gate electrode 103 relative to the barrier metal 102 may affect the edges 112 (corners) of the barrier metal layer/region 102 as in the case of an n-type semiconductor.

At step 203A, a charge density at the barrier metal edges 112 may be increased, such as resulting from the voltage applied to the gate electrode 103 in step 202. In some instances, at step 203B, a Schottky barrier may be changed due to the voltage applied to the gate electrode 103 in step 202. For example, a SB energy barrier height may be lowered due the voltage applied to the gate electrode 103 in step 202. For example, a SB energy barrier width may be decreased due the voltage applied to the gate electrode 103 in step 202. In some instances, a depletion region may be changed in size and shape due the voltage applied to the gate electrode 103 in step 202. The changes to the depletion region may be aligned with the changes to the SB barrier height and barrier width due the voltage applied to the gate electrode 103 in step 202. Reshaping of electrical fields around the barrier metal 102 caused by the voltage applied to T2 may result in the changes in shape to the depletion region. A high-K dielectric material may be used to enhance or shape an electrical field around the edge 112 of the barrier metal 102, and thus affect the shape of the depletion region. A high dielectric constant material with a high breakdown strength (such as dielectric constant greater than 3.5 and breakdown strength greater than 10 kV/cm) may allow increasing the voltage difference, decreasing the distance from the gate electrode 103 to the edges 112, or both. For example, the shaping of the electrical fields around the barrier metal 102 caused by the voltage applied to T2 may result in changing the width of the depletion region at each location and direction near the edge 112 of the barrier metal 102. Electrical or physical changes to the operation of the SB, such as changes to the electrical properties or physical properties of the SB, may be induced by the voltage applied to the gate electrode 103 at step 202. For example, at step 203C the tunneling probability may be increased, inducing an increased reverse bias current flow across the SB. For example, at step 203D, a Schottky barrier may be modulated by the gate electrode voltage, to allow some current to flow in the reverse bias direction according to a thermionic emission mechanism. For example, at step 203E, the gate electrode voltage may induce a reverse bias current flow according to a thermionic-field emission mechanism. At step 204, a reverse bias current may flow across the Schottky barrier.

As the edge effect of the Schottky barrier is enhanced with the application of a voltage to the insulated gate electrodes 103, the current density of the BM transistor 100 may benefit from methods of increasing the length of Schottky barrier edges 112 per unit area of the semiconductor substrate 101. For example, the metal layer may include metal layer structures distributed over the semiconductor substrate 101. For example, the metal layer 102 may include structures, such as line segments, curved segments, circular structures, or perforations, and the gate electrode may include corresponding structures so that an edge of the gate electrode is near the edge of the metal layer structures. For example, the metal layer structures may be distributed in a pattern of repeating shapes. For example, the gate electrodes 103 may include gate electrode structures corresponding to the metal layer structures, such that each gate electrode structure is coaxial with one of the metal layer structure. For example, each gate electrode structure has an edge adjacent to an edge of the corresponding metal layer structure. For example, each gate electrode structure has an edge following an edge of the corresponding metal layer structure. For example, when the metal layer structures are circular, the gate electrode structures will be annular (or ring-shaped) and each gate electrode structure surrounds one of the metal layer structures. For example, when the metal layer structures are square or rectangular, the gate electrode structures will be square or rectangular and each gate electrode structure surrounds one of the metal layer structures. For example, when the metal layer structures are triangular or hexagonal, the gate electrode structures will be triangular or hexagonal and each gate electrode structure surrounds one of the metal layer structures. For example, when the metal layer includes circular perforations, the gate electrode structures will be circular and each gate electrode structure will be inside of one of the circular perforations.

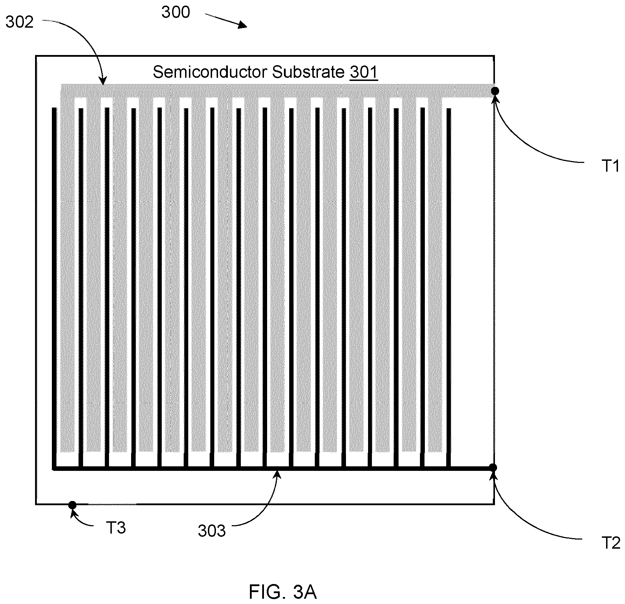

Non-limiting examples of configurations for increasing edge density are shown in FIGs. 3A through 3E. Reference is now made to FIG. 3A, which shows an example of a top-view of a BM transistor 300 with a comb-like structures to increase the edge density of the Schottky barrier. The barrier metal layer may comprise a comb structure, where each comb has multiple teeth or finger structures ("fingers") that increase the edge density. The gate electrode may be an interdigitated comb structure with corresponding teeth or fingers. The gate electrode may be a continuous sheet structure overlaid on the barrier metal layer comb structure, where the gate electrode enhances the charge density at the edges of the barrier metal comb-structure. As used herein, the term "edge density" means the total length of SB edges divided by the semiconductor substrate area. A metal layer 302 may be deposited on a region of a semiconductor substrate 301 in a pattern with parallel interdigitated fingers of the metal layer spaced apart. In between the interdigitated fingers, an insulated gate electrode 303 may be placed at the edges of the fingers and in between fingers to enhance the charge density at the edges of the Schottky barrier. Insulated gate electrode 303 may be insulated from the semiconductor substrate 301 with a high-K dielectric material. Insulated gate electrode 303 may be insulated from the metal layer 302. A terminal T3 may be connected to the semiconductor substrate 301, such as using an ohmic contact. A terminal T1 may be connected to the metal layer 302. A terminal T2 may be connected to the insulated gate electrode 303.

The edge density may also be increased by any barrier metal layer shape that increases the length of SB edges in an area of semiconductor substrate to be greater than the perimeter of the substrate area. For example, when the barrier metal layer is shaped with a grid-like structure of repeating elements, the total SB edges of the barrier metal layer will be greater than the perimeter of the grid structure.

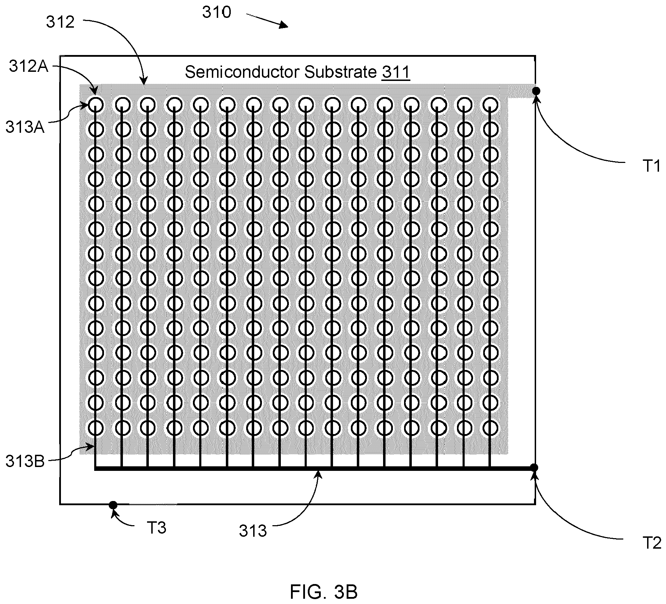

Reference is now made to FIG. 3B, which shows an example of a top-view of a BM transistor device 310 with circular perforations to increase the edge density. A metal layer 312 may be deposited on a region of a semiconductor substrate 311 in a pattern with circular perforations 312A of the metal layer spaced apart. Insulated gate electrode 313 includes a plurality of circular gate electrodes 313A. At the edges of each circular perforation 312A of the metal layer 312 a circular gate electrode 313A may be placed to enhance the charge density at the edges of the Schottky barrier (at the edges of each perforation 312A). Each circular gate electrode 313A may be insulated from the edge of each circular perforation 312A with a low-K material or a high-K material. Each circular gate electrode 313A may be insulated from the semiconductor substrate 311 with a high-K material. Gate busbars 313B may be used to electrically connect each circular gate electrode 313A to the insulated gate electrode 313 and a terminal T2. Gate busbars 313B may be insulated from the semiconductor substrate 311 and the metal layer 312. A terminal T3 may be connected to the semiconductor substrate 311, such as using an ohmic contact (not shown). A terminal T1 may be connected to the metal layer 312. In alternative configurations, the circular perforations 312A may be placed across the metal layer 312 in a diagonal pattern to pack more circular perforations 312A per unit area of semiconductor substrate 311. The terminals T1, T2, and T3 may be isolated. Circular gate electrodes 313A may be shaped as disks (not shown) or annular rings.

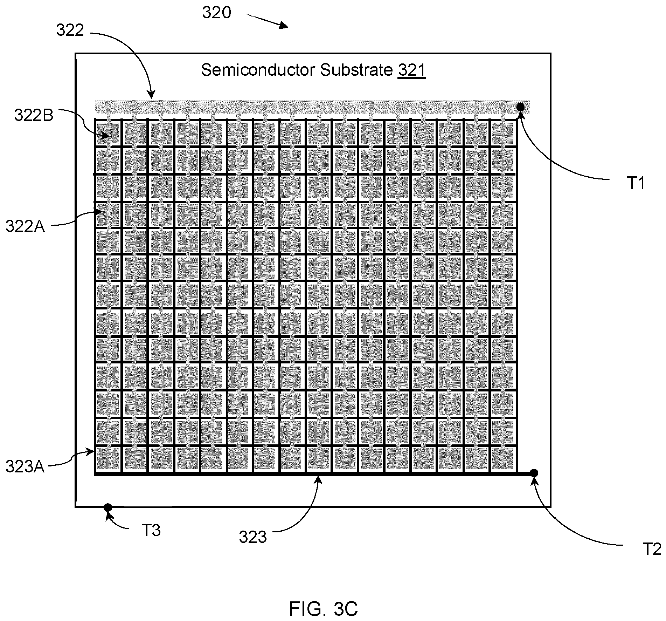

Reference is now made to FIG. 3C, which shows an example of a top-view of a BM transistor device 320 with rectangular metal structures 322A to increase the edge density. A metal layer 322 may be deposited on a region of a semiconductor substrate 321 in a spaced apart pattern of rectangular structures 322A. Insulated gate electrode 323 may include a grid of rectangular gate electrodes 323A, and metal layer 322 may include a grid of rectangular structures 322A, where each gate electrode 323A of the grid surrounds a rectangular structure 322A. For example, around each metal structure 322A, an insulated gate electrodes 323A may be placed at the edges of the structures 322A in a rectangular grid configuration 323A to enhance the edge density of the Schottky barrier (at the edges of each structure 322A). Each gate electrode rectangular configuration 323A may be insulated from the edge of each rectangular structure 322A with a dielectric, such as a low-K dielectric material or a high-K dielectric material. Each rectangular gate electrode configuration 323A may be insulated from the semiconductor substrate 321 with a high-K dielectric material. Metal busbars 322B may be used to electrically connect each rectangular structure 322A to the metal layer 322 and a terminal T1. Metal busbars 322B may be insulated from the semiconductor substrate 311 and the gate electrodes 323A. A terminal T3 may be connected to the semiconductor substrate 321, such as using an ohmic contact. A terminal T1 may be connected to the metal layer 322. The terminals T1, T2, and T3 may be isolated.

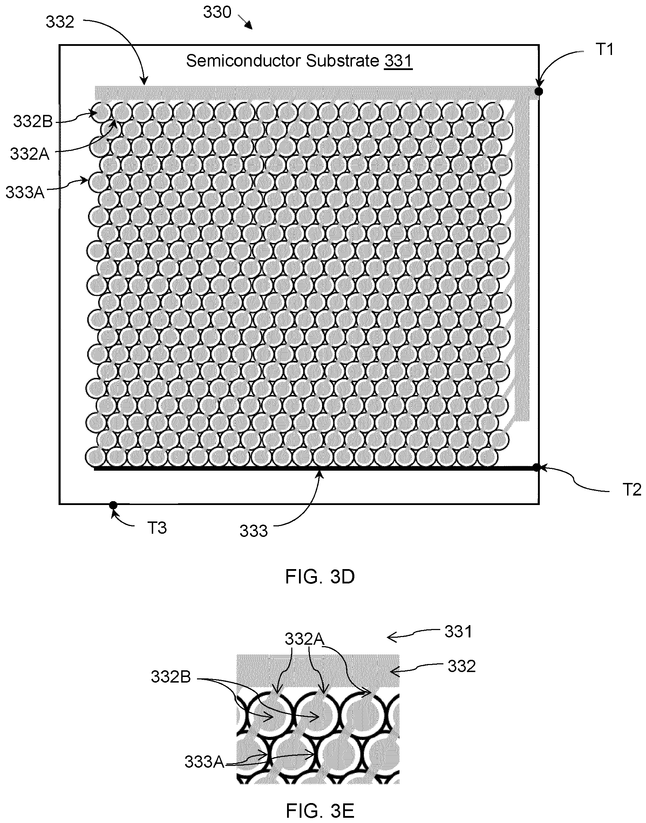

Reference is now made to FIG. 3D, which shows an example of a top-view of a BM transistor device 330 with circular interconnected metal SB regions (such as a circular structures) 332B and surrounding circular gate electrodes 333A. A metal layer 332 may be deposited on a region of a semiconductor substrate 331 in a configuration wherein circular structures 332B of the metal layer are spaced apart in a pattern. Insulated gate electrode 333 may include a plurality of circular gate electrodes 333A. Around each circular structure 332B, part of a circular gate electrode 333 may be placed at the edges (or perimeter) of the circular structures 332B. Each circular gate electrode 333A may be insulated from the edge of each circular structure 332B. Circular gate electrodes 333A may comprise annular or polygon (such as hexagonal) configurations to enhance the charge density at the edges of the Schottky barrier (at the edges of each circular structure 332B). Each circular gate electrode 333A may be insulated from the semiconductor substrate 321 with a high-K dielectric material. Insulated metal busbars 332A may be used to electrically connect each circular structure 332B to metal layer 332 and a terminal T1. Insulated metal busbars 332A may be insulated from the semiconductor substrate 311 and the circular gate electrodes 333A. A terminal T3 may be connected to the semiconductor substrate 321, such as using an ohmic contact. A terminal T2 may be connected to the insulated gate electrode 333, and the circular gate electrodes 333A. Circular gate electrodes 333A may be interconnected using adjacent connected edges of each circular gate electrodes 333A. For example, the circular gate electrodes 333A may form in interconnected hexagonal or annular configuration. The terminals T1, T2, and T3 may be isolated.

Reference is now made to FIG. 3E, which shows a detailed top view of FIG. 3D where the metal layer busbars 332A may be insulated from the semiconductor substrate 331 and circular gate electrodes 333A, such as insulated with an insulating layer, an air bridge, or the like (not shown).

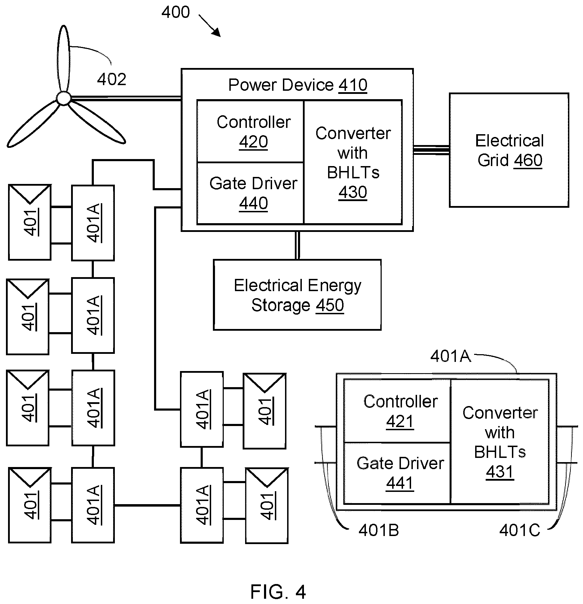

As an example application, a renewable power generation system is illustrated in FIG. 4. FIG. 4 shows an example of an example system 400 for power conversion circuitry comprising BM transistors 430 for power device 410. A power device 410 (for example, an inverter) may comprise gate driver 440, controller 420, or converter with BM transistors 430. Power conversion device 410 may convert power, for example, DC power from one or more solar panels 401 optionally using power optimizers 401A, or AC power from wind turbines 402, and/or the like, to DC power (for example, an inverter comprising a DC-DC power converter for this purpose) for charging an electrical storage device 450 (for example, a battery, a compressed air electrical storage, a thermal electrical storage, or the like). The power device 410 may convert power, for example, DC power from one or more solar panels 401 optionally using power optimizers 401A, or AC power from wind turbines 402, and/or the like, to AC power for powering a load or for feed in to an electrical grid 460. The power optimizers 401A may comprise input and output terminals 401B and 401C, controller 421, gate drivers 441, or DC/DC converters with one or more BM transistors 431.

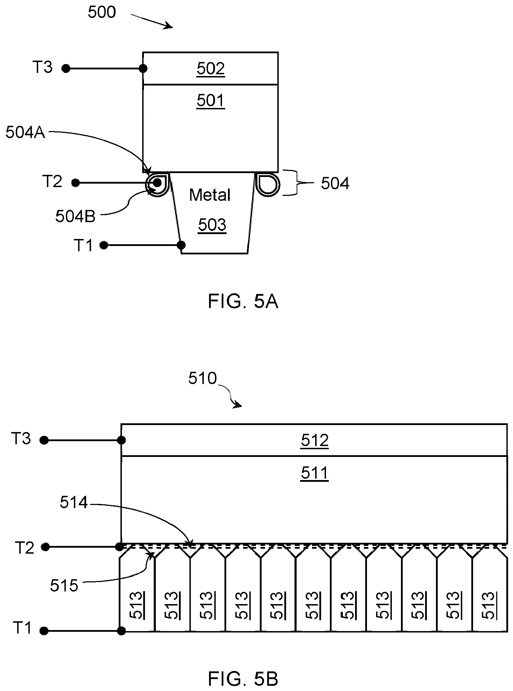

Reference is now made to FIG. 5A, which shows a cross-section view of a BM transistor 500 with reverse bias current enhancing whisker gate electrode 504 on the semiconductor substrate. This figure may represent the BM transistor in an electrical orientation where a semiconductor substrate 501 is at the top of the drawing and where a metal layer 503 is at the bottom of the drawing. The semiconductor substrate 501 may have an ohmic contact 502 positioned on a surface of semiconductor substrate 501. The ohmic contact 502 may have an electrically connected terminal T3. The metal layer 503 may be positioned or deposited on a surface of semiconductor substrate 501, thereby forming a SB. Metal layer 503 may have an electrically connected terminal T1. An insulated gate electrode (e.g., the reverse bias current enhancing whisker gate electrode 504) may be positioned near edges of metal layer 503 and semiconductor substrate 501 contact area. The insulated gate electrode 504 may be positioned and used to increase the reverse bias current flow. Gate electrode 504 may comprise an insulate layer 504A (or gap) surrounding a conducting lead 504B of the gate electrode 504. Conducting lead 504B lead may be shaped to enhance a charge density at the edges of the SB, such as comprising an acute angle in cross section directed towards the SB edges of the metal layer 503.

Reference is now made to FIG. 5B, which shows an example of a cross-section view of a BM transistor 510 with singular Schottky regions and a reverse bias current enhancing gate electrode grid 514 insulated from a semiconductor substrate 511. FIG. 5B may represent the BM transistor 510 in an electrical orientation wherein the semiconductor substrate 511 may be at the top of the figure and metal layer 513 may be at the bottom of the figure. Insulated gate electrode grid 514 may form a network of gaps between the conducting elements of the gate electrode grid 514. Metal layer 513 structures may be placed in the gaps and interconnected above the gate electrode grid 514. Metal layer 513 structures may be insulted by air bridges 515 from the gate electrode grid 514. A terminal T3 may be connected to an ohmic contact 512, and the ohmic contact 512 may be electrically connected semiconductor substrate 511. A terminal T2 may be connected to the gate electrode grid 514, and a terminal T1 may be connected to the metal layer 513.

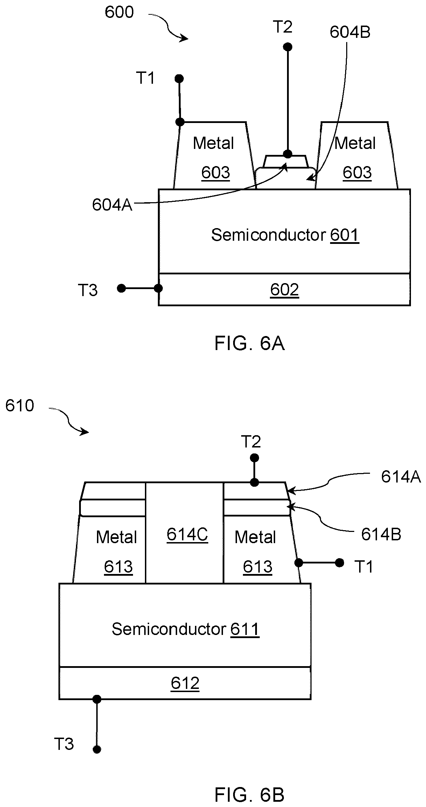

Reference is now made to FIG. 6A, which shows an example of a cross-section view of a BM transistor 600 with reverse bias current enhancing gate electrode 604A on the semiconductor substrate. The terms used for the terminals of the BM transistor terminals may be similar to those used in MOSFETs (source, drain, gate), similar to those used in bipolar junction transistors (emitter, collector, base), similar to those used in insulated-gate bipolar transistors (emitter, collector, gate), or using new terms (such as anode, cathode, and gate). A terminal T1 may be connected to a metal layer 603 comprising edges, where gaps between edges may comprise a gate electrode 604A. Gate electrode 604A may be positioned over an insulating layer 604B between gate electrode 604A and the semiconductor 601. Insulating layer 604B may comprise a high-K dielectric material. Metal layer 603 may be adjacent to semiconductor substrate 601, thereby forming a SB. Semiconductor substrate 601 may be adjacent to an ohmic contact 602, and the ohmic contact 602 may be connected to a terminal T1. A terminal T2 may be connected to the gate electrode 604A. In an n-type BM transistor, the terminal T1 may be considered a source or emitter voltage, terminal T2 may be considered a gate or base voltage, or terminal T3 may be considered a drain or collector voltage. In a p-type BM transistor, terminal T1 may be considered the drain or collector voltage, terminal T2 may be considered the gate or base voltage, or terminal T3 may be considered the source or emitter voltage.

Reference is now made to FIG. 6B, which shows an example of a cross-section view of a BM transistor 610 with reverse bias current enhancing gate electrode 614A over the barrier metal. Transistor 610 may include a semiconductor substrate 611 with ohmic contact 612. Ohmic contact 612 may be connected to transistor terminal T3. Barrier metal 613 may be in contact with the semiconductor substrate 611, and may be connected to a terminal T1. A gate electrode 614A may be positioned above the barrier metal 613 and separated by an insulation layer 614B, such as a layer of low-K dielectric material. For example, low-K dielectric material of insulation layer 614B may include a material with a dielectric constant of less than 3.0. For example, a low-K dielectric material may include a material with a dielectric breakdown strength of greater than 10 kV/cm. For example, a low-K dielectric material may be an air gap with a dielectric constant near 1.0. A gate terminal T2 may be electrically connected to the gate electrode 614A. A high-K dielectric material insulating layer 614C may be located between the gate electrode 614A and the semiconductor substrate 611. For example, high-K dielectric material insulating layer 614C may include a material with a dielectric constant greater than or equal to 3.5. For example, high-K dielectric material insulating layer 614C may comprise silicon dioxide, hafnium dioxide, or one or more of the materials listed in TABLE 3. This is a list of some of the materials known to insulate between conducting or semiconducting structures on a semiconductor substrate, and it is not a limiting list of examples. For example, new materials and/or manufacturing processes may be developed that may be used to produce a BM transistor. The dielectric constant is the permittivity of the material divided by the permittivity of vacuum, and may be referred to as the relative permittivity.

As used herein, the terms low-K dielectric material and high-K dielectric material mean that the low-K material has a dielectric constant smaller than the high-K dielectric material. For example, a low-K dielectric material may comprise a material with a dielectric constant of less than 3.0. For example, a low-K dielectric material may comprise a fluid, such as air. For example, an air gap or air bridge may be used as a low-K dielectric material. The terms low and high are relative values when both appear in the device. A high-K dielectric material may by a material with a dielectric constant equal to or higher than that of silicon dioxide.

TABLE 3: Materials with high dielectric constant and high dielectric strength for us as dielectric insulation layers.

| Material |
| --- |
| Silicon dioxide |
| Sapphire |
| GaAs |
| Titanium dioxide |
| Strontium titanate |
| Barium titanate |
| Calcium copper titanate |
| Hafnium dioxide |
| Aluminum oxide |
| Silicon nitride |
| Hafnium silicate |

Using insulating layers with at least two regions of different dielectric constants, such as at least one region of low-K dielectric material and at least one region of high-K dielectric material, allow increasing the charge density at the SB edge of the BM transistor. Regions of high-K material are placed between the gate electrode and the semiconductor substrate. Regions of high-K material are placed between the gate electrode and the SB edge. Regions of low-K material (such as air gaps) are placed between the gate electrode and barrier metal layer other than the SB edge, such as other regions of the barrier metal layer.

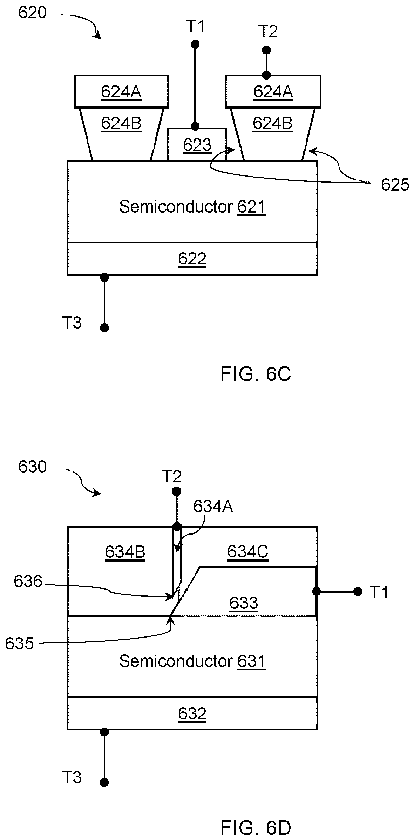

Reference is now made to FIG. 6C which shows an example of a cross-section view of a BM transistor 620 with reverse bias current enhancing gate electrode 624A with an air gap 625. BM Transistor 620 may include a semiconductor substrate 621 with ohmic contact 622. Ohmic contact 622 may be connected to transistor terminal T3. Metal layer 623 may be in contact with semiconductor substrate 621 to create a Schottky barrier between the metal layer 623 and the semiconductor substrate 621. Metal layer 623 may be connected to a terminal T1. Gate electrode 624A may be positioned above the semiconductor substrate 621 and separated by an insulation layer 624B. Gate electrode 624A may be adjacent to the metal layer 623 producing an air gap 625 positioned between the gate electrode 624A and the metal layer 623. The air gap 625 is shown schematically, and the distances between the metal layer 623, the high-K dielectric material insulating layer 624B, and the gate electrode 624A, may be configured differently. For example, the distances between these elements may be determined by a configured breakdown voltage. A gate terminal T2 may be electrically connected to the gate electrode 624A.

Reference is now made to FIG. 6D which shows an example of a cross-section view of a BM transistor 630 with reverse bias current enhancing gate electrode 634A and two dielectrics 634B and 634C. Transistor 630 may include a semiconductor substrate 631 with ohmic contact 632. Ohmic contact 632 may be connected to transistor terminal T3. Metal layer 633 may be in contact with semiconductor substrate 631 to create a Schottky barrier between the metal layer 633 and the semiconductor substrate 631. Metal layer 633 may be connected to a terminal T1. Metal layer 633 may include a sharp, whisker-like, acute-angle edge 635 located adjacent to the semiconductor substrate 631. The acute angle edge 635 may increase a charge density in the metal layer 633 at the edge 635. The gate electrode 634A may include a whisker-like projection 636 positioned near the semiconductor substrate 631 and SB edge 635 of the metal layer 633.

A gate electrode structure with an acute angle in cross section near the SB edge may increase the charge density at the edge. A gate electrode structure with a very small radius of curvature near the SB edge may increase the charge density at the edge. An acute angle as seen in cross-section may be called a whisker when the angle is less than 45 degrees. An angle of the cross section may be measured as being different from 90 degrees, such as a cross-section angle less than 80 degrees. Similarly, a barrier metal structure with an acute angle in cross section, and directed towards the gate electrode, may increase the charge density accumulation at the edge of the SB.

The gate electrode 634A may be separated from the semiconductor substrate 631 by the insulation layer 634B comprising a high-K dielectric material. For example, insulation layer 634B may include a material with a dielectric constant greater than 3.5. For example, insulation layer 634B may include silicon dioxide, hafnium dioxide, or one or more of the materials in TABLE 3. Gate electrode 634A may be separated from the metal layer 633 by an insulation layer 634C which may comprise a low-K dielectric constant. For example, insulation layer 634C may be an air gap. For example, insulation layer 634C may comprise porous silicon dioxide that may comprise a dielectric constant of less than 3.0. For example, insulation layer 634C may comprise silicon dioxide doped with carbon (e.g., organosilicate glass) which may comprise a dielectric constant of less than 3.0. A gate terminal T2 may be electrically connected to the gate electrode 634A.

A material (such as an insulation layer, a metal layer, or a dielectric layer) may be deposited (such as on a semiconductor substrate, a metal layer, and/or a mask) by chemical vapor deposition (CVD), plasma enhanced CVD (PECDV), chemical solution deposition (CSD), pulsed laser deposition (PLD), sputtering, metal organic chemical vapor deposition (MOCVD), or the like. For example, an insulation layer comprising titanium dioxide may be deposited using CVD. For example, an insulation layer comprising titanium dioxide may be deposited using PECVD. For example, an insulation layer comprising hafnium dioxide may be deposited using PLD. For example, an insulation layer comprising calcium copper titanate ($CaCu_3Ti_4O_{12}$ - CCTO) may be deposited by PLD. For example, a CCTO insulation layer may be deposited by MOCVD. This is a list of some of the processes known to deposit materials in semiconductor fabrication, and it is not a limiting list of example processes. For example, new manufacturing processes may be developed that may be used to produce a BM transistor. Other materials may be deposited using the various chemical or physical deposition techniques listed herein, as well as other deposition techniques may be suitable for the manufacturing processes of BM transistors described herein. The materials and processes may be selected based on the availability of processes at a particular fabrication facility at the time the BM transistor is designed and manufactured at that facility.

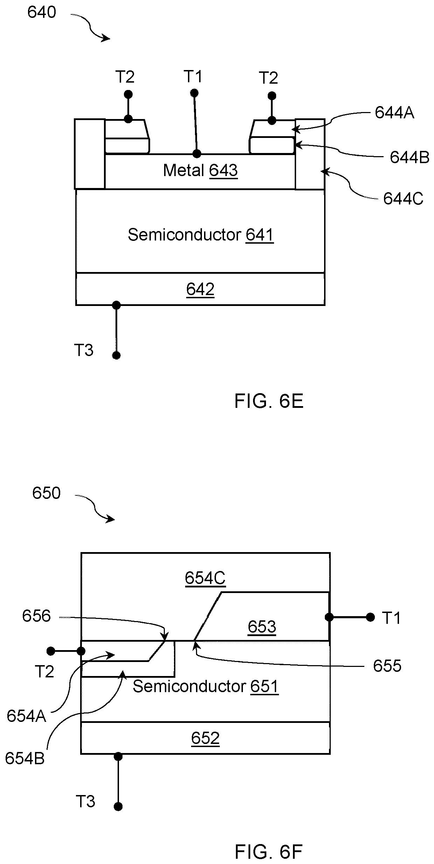

Reference is now made to FIG. 6E which shows an example of a cross-section view of a BM transistor 640 with reverse bias current enhancing gate electrode 644A over the edges of the barrier metal 643. BM transistor 640 may include a semiconductor substrate 641 with ohmic contact 642. Ohmic contact 642 may be connected to transistor terminal T3. Barrier metal 643 may be in contact with semiconductor substrate 641, and may be connected to a terminal T1. A gate electrode 644A may be positioned above the edges of barrier metal 643 and separated from barrier metal 643 by an insulation layer 644B. A gate terminal T2 may be electrically connected to the gate electrode 644A. A high-K dielectric material insulating layer 644C may be located between the gate electrode 644A and the semiconductor substrate 641. For example, high-K dielectric material insulating layer 644C may include a material with a dielectric constant greater than 3.5. For example, high-K dielectric material insulating layer 644C comprises silicon dioxide, hafnium dioxide, or one or more of the materials in TABLE 3.

Reference is now made to FIG. 6F which shows an example of a cross-section view of a BM transistor 650 with reverse bias current enhancing gate electrode 654A and a high-K dielectrics insulating layer 654B between the gate electrode 654A and the semiconductor substrate 651. Transistor 650 may include a semiconductor substrate 651 with ohmic contact 652. Ohmic contact 652 may be connected to transistor terminal T3. Metal layer 653 may be in contact with semiconductor substrate 651 to create a Schottky barrier between the metal layer 653 and the semiconductor substrate 651. Metal layer 653 may be connected to a terminal T1. Metal layer 653 may include a sharp, whisker-like edge 655 located adjacent to the semiconductor substrate 651. The metal layer 653 acute angle edge 655 may increase a charge density in the metal layer 653 at the edge 655. An insulated gate electrode 654A may include a whisker-like projection 656 positioned near the semiconductor substrate 651 and metal layer 653 interface edge 655.

Implementing a whisker like edge may be performed with a semiconductor integrated circuit fabrication plant (fab). For example, etching a wedge shaped trench, depositing an insulation layer, depositing a gate electrode metal, and remove at least some of the resulting structure (by grinding, etching, or liftoff) can produce a gate electrode with an acute angle as seen in cross section. For example, FIGs. 5A, 6A, 6B, 6D, 6F, 10F, and 10K show gate electrodes with acute angle cross-sections. Similarly, barrier metal layers may incorporate edges with acute angles as seen in cross section. For example, FIGs. 5A, 6A, 6B, 6D, 6E, 6F, 10F, and 10K show barrier metal layers with acute angle cross-sections.

The gate electrode 654A may be separated from the semiconductor substrate 651 by an insulation layer 654B comprising a high-K dielectric material and an insulation layer 654C comprising a low-K dielectric material. For example, insulation layer 654B may include a material with a dielectric constant greater than 3.5. For example, insulation layer 654B may include silicon dioxide, hafnium dioxide, or one or more of the materials in TABLE 3. Gate electrode 654A may be separated from the metal layer 653 by a low-K insulation layer 654C. For example, insulation layer 654C may be an air gap. For example, insulation layer 654C may comprise porous silicon dioxide which may comprise a dielectric constant of less than 3.0. For example, insulation layer 654C may comprise silicon dioxide doped with carbon (e.g., organosilicate glass) which may comprise a dielectric constant of less than 3.0. A gate terminal T2 may be electrically connected to the gate electrode 654A.

Experimental results for several prototype BM transistors show that applying a gate voltage may increase the current or current density by a factor of 10,000 to 100,000. While a reverse bias leakage current is an edge effect of the SB, and may thus be represented as units of amperes current per millimeter length of SB edge, the unit length of SB edges per square millimeter may be combined to produce a current density unit of amperes current per square millimeter. For example, a BM transistor example may comprise an n-type semiconductor substrate, a single metal layer comprising platinum as a comb-structure. A gate metal and an insulating layer comprising alumina may be overlaid on the comb like structure of the barrier metal. For example, when a voltage of 2.8 V is applied to a semiconductor (drain) relative to the metal (source), and when a voltage of 15 V is applied to the gate relative to the metal, a reverse bias current density may be 0.02 A/mm^2. When the gate electrode has the same voltage as the barrier metal (substantially zero voltage difference or including a short circuit between them), the reverse bias current density through the gate may be 10 micro-A/mm^2. For example, BM transistors may be implemented using a p-type semiconductor substrate where the gate voltage T2 may be lower than the metal layer, and the current flows from the metal layer to the ohmic contact.

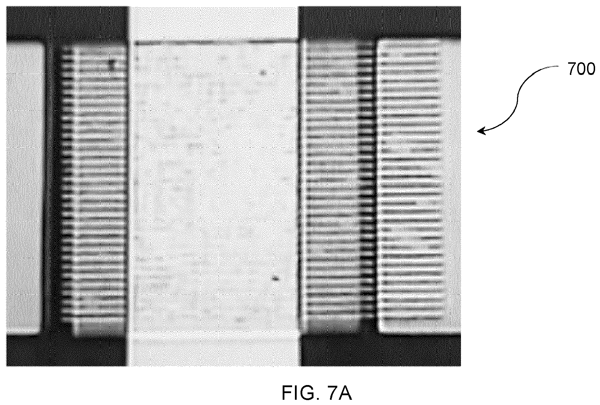

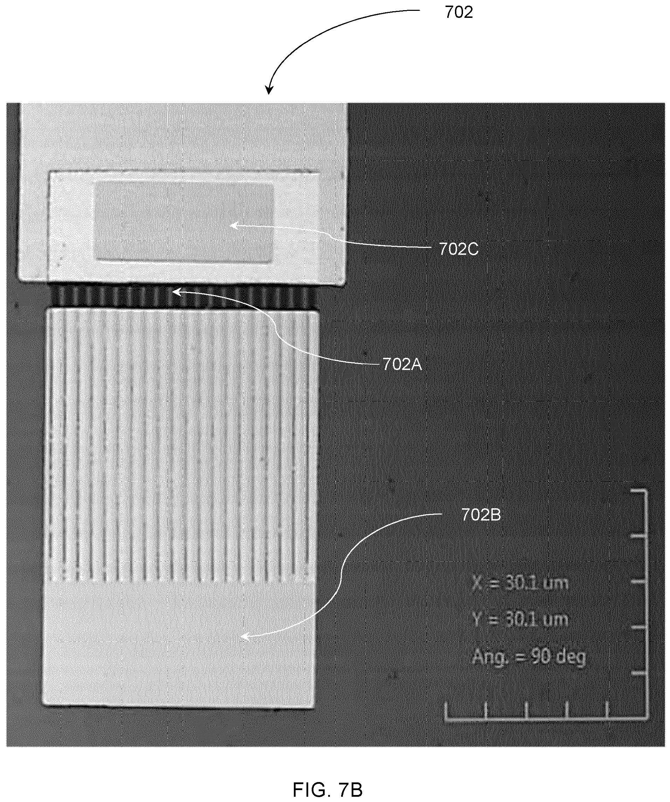

According to experimental results, a BM transistor may comprise a 32-element comb structure metal layer (such as using platinum), an n-type semiconductor substrate (die area of 0.005 mm^2 and contour length of 6.4 mm), and an insulating layer comprising alumina. Reference is now made to FIG. 7A, which shows, an example microscopic image 700 of a BM transistor with 32 element comb-like metal layer structure. Reference is now made to FIG. 7B, which shows, and example microscopic image 702 of a BM transistor with 20 element comb-like barrier metal layer structure. A comb-shaped metal layer 702A comprising teeth or finger structures is overlaid with an oxide layer and a gate electrode layer 702B. The comb structure is connected to terminal 702C for bonding the transistor.

For example, when a voltage of 3.4 V is applied to an n-type semiconductor substrate (drain) relative to a metal layer (source), and when a voltage of 15 V is applied to a gate relative to the metal layer (source), a reverse bias current density may be 0.8 amperes per millimeter square (A/mm^2). For example, when the gate is the same voltage as the metal (substantially zero voltage difference), the reverse bias current density through the BM transistor (drain to source) may be at or near a noise level of a test equipment. For example, a gain of the BM transistor is about 90 dB (current ratio of 32,000).

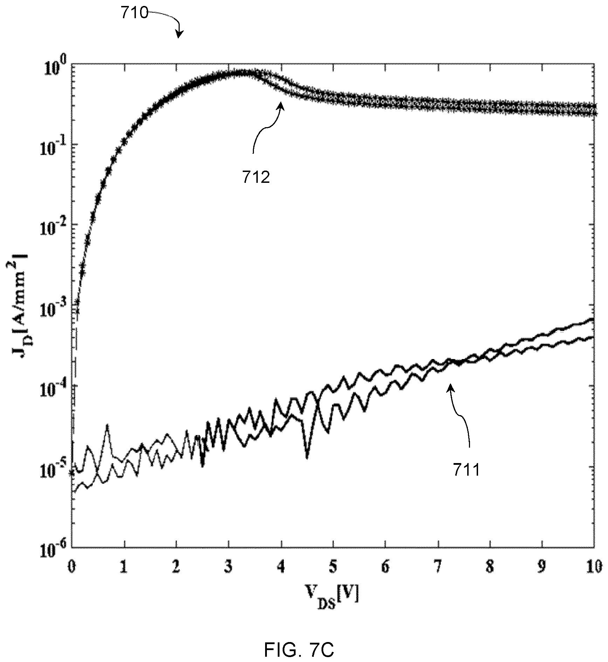

Reference is now made to FIG. 7C, which shows, a graph 710 of current density versus drain-source voltage (Vds) of a BM transistor with 32 element comb-like metal layer structure. Data line 711 shows the current density with 0 V gate voltage relative to the source (Vgs), and data line 712 shows the current density with 15 V gate Vgs.

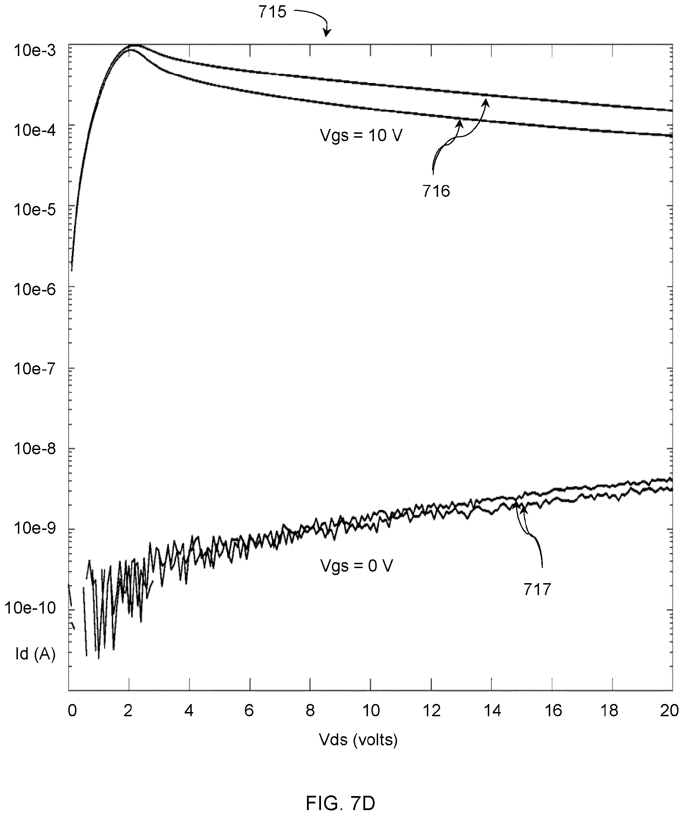

Reference is now made to FIG. 7D, which shows, a graph 715 of current (Id) in amperes (A) versus Vds in volts (V) of a second example BM transistor (Pt over Si wafer) with 32 element comb-like metal layer structure. Data line 717 shows the current density with 0 V gate voltage (Vgs), and data line 716 shows the current density with 10 V gate voltage (Vgs).

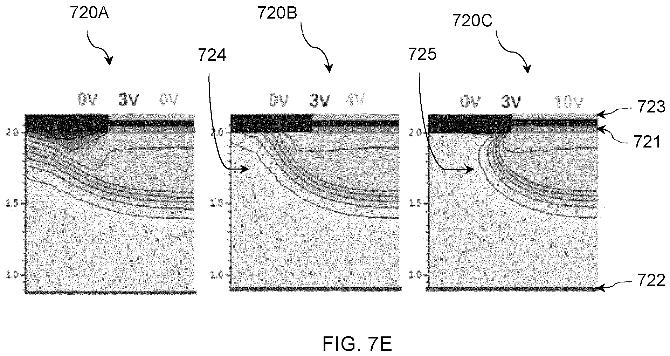

Reference is now made to FIG. 7E which shows maps 720A, 720B, and 720C of simulation results of equipotential lines of the BM transistor 610 of FIG. 6B. In the simulation for map 720A, a voltage of 3 V was simulated on an ohmic contact 722 (such as terminal T3 described herein) relative to a metal layer 721 (such as terminal T1 described herein), and a voltage of a gate electrode 723 (such as terminal T2 described herein) is set at 0 V relative to the metal layer 721. The simulation used for map 720A shows no substantial change in the depletion region based on this simulation. In the simulation for map 720B, the voltage of gate electrode 723 is increased to 4 V, and the simulation shows a shift 724 of the depletion region towards the edge of the metal layer 721. In the simulation for map 720C, the voltage of gate electrode 723 is increased to 10 V, and the simulation shows a shift 725 of the depletion region towards the edge of the metal layer 721. The shift 725 of map 720C appears stronger than the shift 724 of map 720B. These simulations show how the voltage on the gate electrode 723 (terminal T2) of the BM transistor 610 of FIG. 6B may decrease the depletion region and allow increased reverse bias positive current to flow from the ohmic contact 722 (terminal T3) to the metal layer 721 (terminal T1).

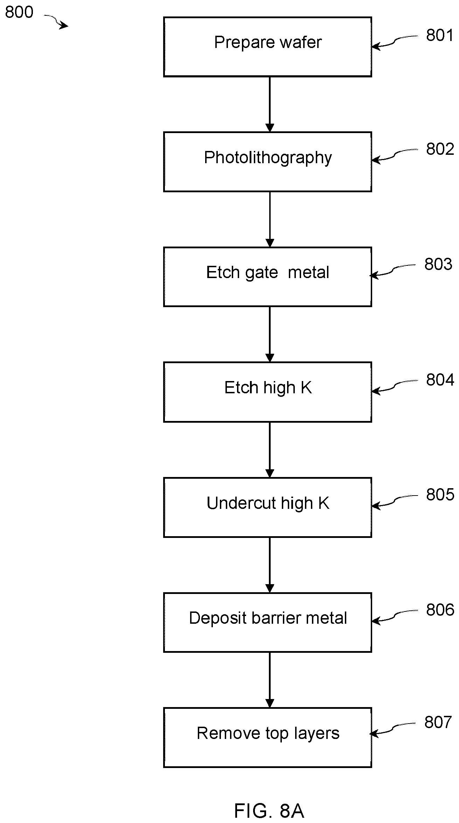

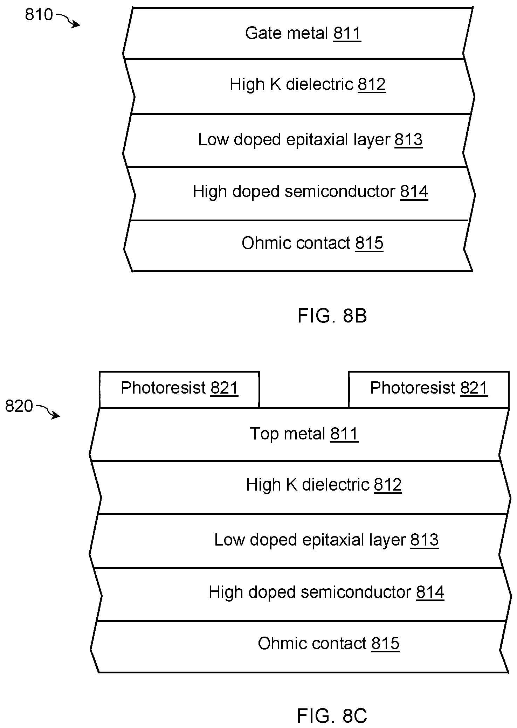

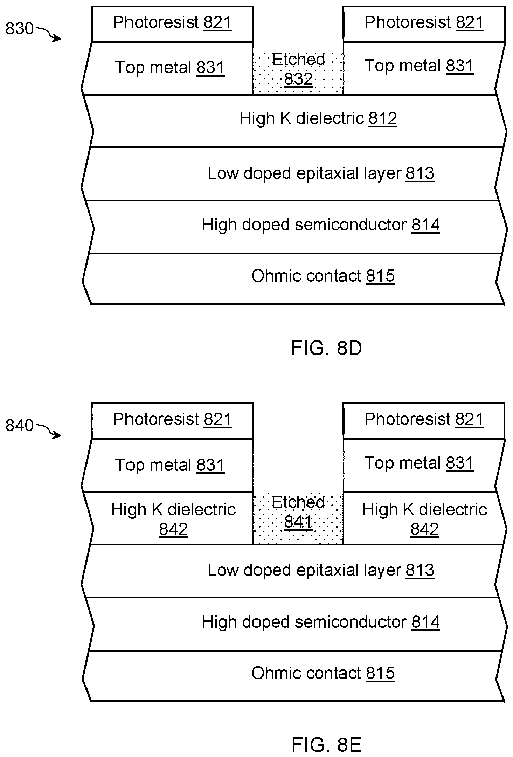

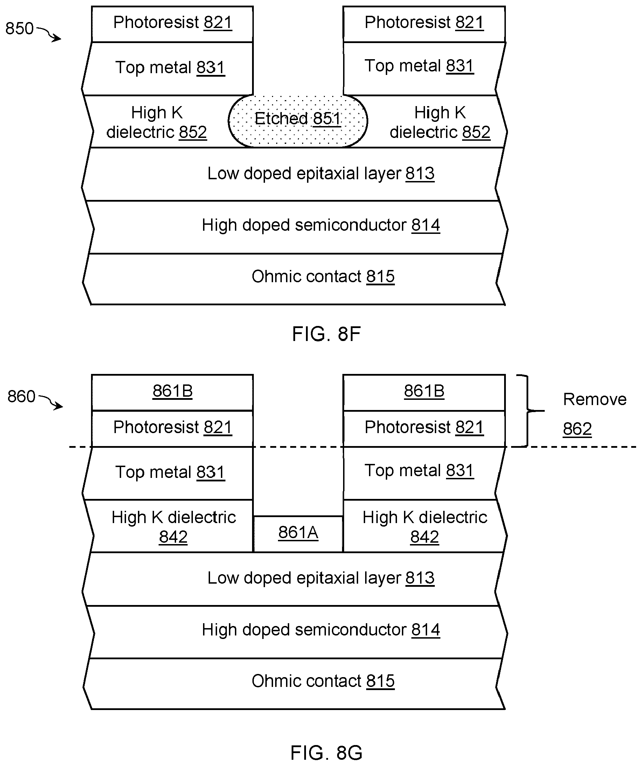

Method of manufacturing may allow using one or more mask in the fabrication process to create an integrated circuit comprising a Schottky barrier transistor. Reference is now made to FIG. 8A, which shows a flowchart 800 of a method of manufacturing a BM transistor using a single mask, as well as FIGs. 8B-8H, which show cross-section views of examples of a wafer consistent with the steps of method 800. A wafer may be prepared as at step 801, which may correspond to wafer 810 of FIG. 8B. Wafer 810 may be prepared in step 801, and wafer 810 may comprise a gate metal layer 811, a high-K dielectric insulating layer 812, a low doped epitaxial layer 813 (such as an epitaxial layer), a high doped semiconductor layer 814, and an ohmic contact 815. Photolithography of wafer 810 may be performed as at step 802, such as to produce a wafer 820 comprising a photoresist layer 821 selectively over some parts of gate metal 811. Gate metal 811 may be etched as at step 803 to remove the metal layer 810 in areas where there may be no photoresist 821, such as etched area 832, and produce etched metal layer 831 of wafer 830. At step 803, the high-K dielectric insulating layer 812 of wafer 830 may be etched in areas where there is no photoresist 821, such as etched area 841, to produce an etched high-K dielectric material insulating layer 842 of wafer 840. For example, the high-K dielectric material insulating layer 812 may be etched 802 using a dry etching process. At step 805, high-K dielectric material insulating layer 812 of wafer 830, or 842 of wafer 840, may be undercut (e.g., such as by etching area 851 to produce an undercut high-K dielectric material insulating layer 852 of wafer 850). Etched region with undercut 851 may be produced from wafer 840 as a second etching step after step 804, or in a single etching step combining the etching of steps 804 and 805.

Undercut 851 may be produced in different configurations or shapes, depending on the type of etching (wet etching, dry etching, laser etching, isotropic etching, directional etching, vertical etching, plasma etching, or metal assisted chemical etching) materials and parameters for the etching process. For example, etching with isotropic radial etching, anisotropic wet etching, reactive ion etching, sputter etching, ion milling, ion beam assisted etching, plasma etching, or reactive ion beam etching may produce different shaped recesses or trenches, depending on the material being etched and the etching parameters. For example, a concave undercut may be configured. This is a list of some of the processes known to remove materials in semiconductor fabrication, and it is not a limiting list of example processes. For example, new manufacturing processes may be developed that may be used to produce a BM transistor.

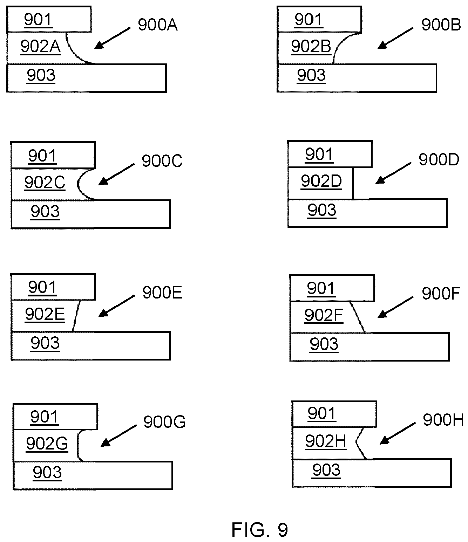

Reference is now made to FIG. 9, which shows an example of cross-section view of example shapes for undercuts of a BM transistor. Metal layer 901 may be the same as gate metal 811 of FIGs. 8D-8H. Low doped epitaxial layer 903 may be the same as low doped epitaxial layer 813 of FIGs. 8B-8H. Undercut 900A results in a high-K dielectric material insulating layer 902A with an upward-facing concave shape. Undercut 900B results in a high-K dielectric material insulating layer 902B with a downward-facing concave shape. Undercut 900C results in a high-K dielectric material insulating layer 902C with a sidefacing concave shape. Undercut 900D results in a high-K dielectric material insulating layer 902D with a flat shape perpendicular to the wafer. Undercut 900E results in a high-K dielectric material insulating layer 902E with a downward-facing flat shape. Undercut 900F results in a high-K dielectric material insulating layer 902F with an upward-facing flat shape. Undercut 900G results in a high-K dielectric material insulating layer 902G with slightly rounded corners. Undercut 900H results in a high-K dielectric material insulating layer 902H with a bevel shape.

For example, the high-K dielectric material insulating layer 812 may be etched 802 using a wet etching process. At step 806, a metal layer 861A and 861B (or metal layer 871A and 871B) may be deposited over the entire wafer 840 (or wafer 850), producing wafer 860 (or wafer 870 respectively). The top layers of wafer 860, photoresist 821, and metal 861B (metal over the photoresist), may be removed (such as at step 807) in their entirety, as may be shown at 862. For example, top layers may be removed by grinding. The top layers of wafer 870, photoresist 821, and metal 861B (metal over the photoresist), may be removed (such as at step 807), as may be shown at 862.

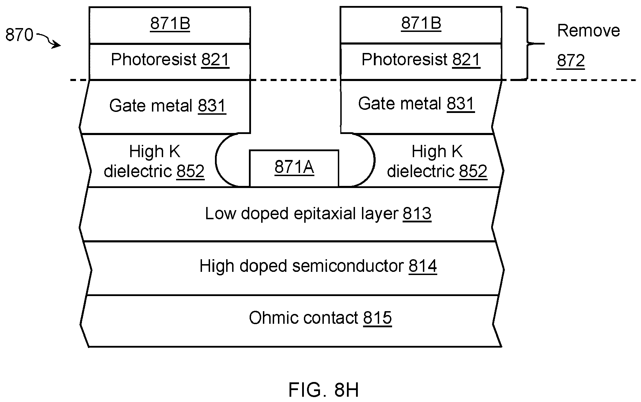

The advantages of undercutting high-K dielectric material insulating layer 812 or 842 may include increasing the air gap between the gate metal (as at gate metal 831) and the barrier metal layer (as at 871A). The air gap may contribute to increasing the breakdown voltage between the gate metal and the barrier metal layer. The combined dielectric path between the gate electrode and the barrier metal layer may contribute to the breakdown voltage. For example, increasing the distance between the gate electrode and the barrier metal layer will produce a higher breakdown voltage. For example, by including less high-K dielectric material (and more air gap or low-K material) between the gate electrode and the barrier metal layer, the breakdown voltage may be increased. The undercut shapes, such as may be shown schematically in FIGs. 6C, 8F, and 8H, may be shaped by the wet etching process to be concave upward, concave downward, or both. The amount of time, etching solution, circulation, temperature, etc. may be configured or adjusted produce the desired undercut shape. For example, the undercut shape may be configured by adjusting the etching parameters according to the specific processes, materials, dimensions, or etching agents.

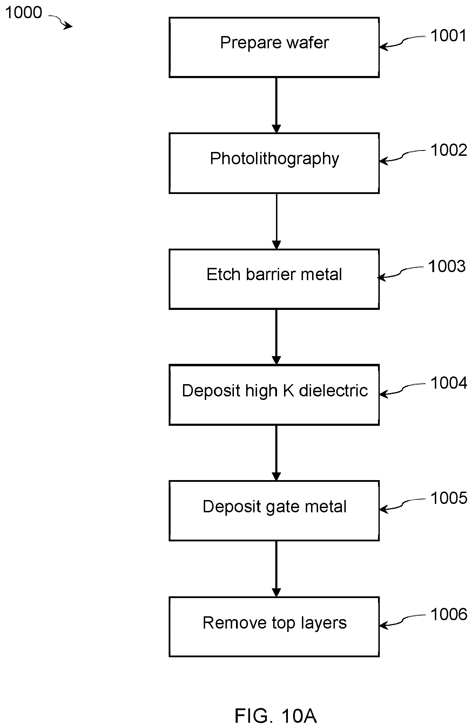

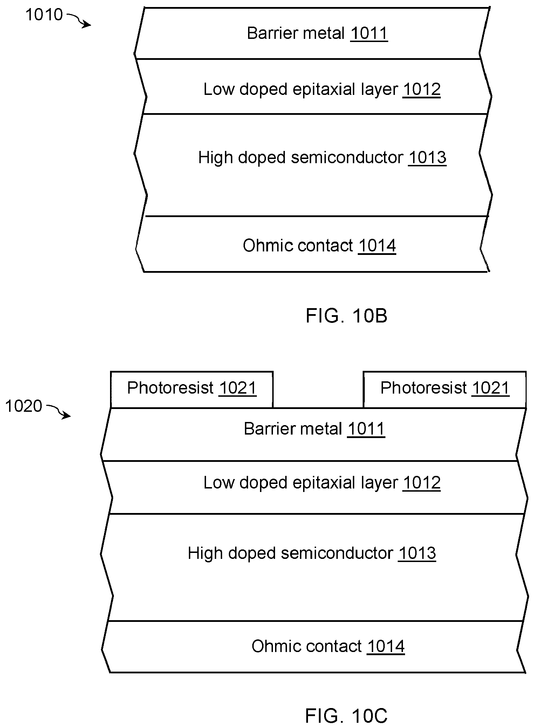

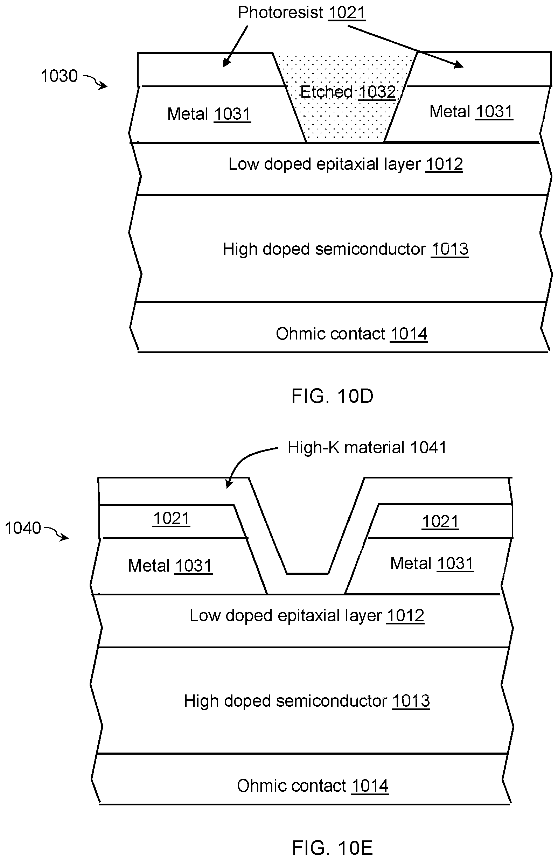

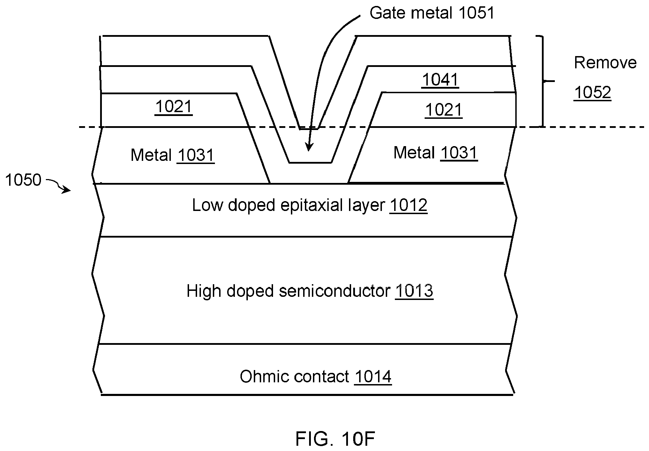

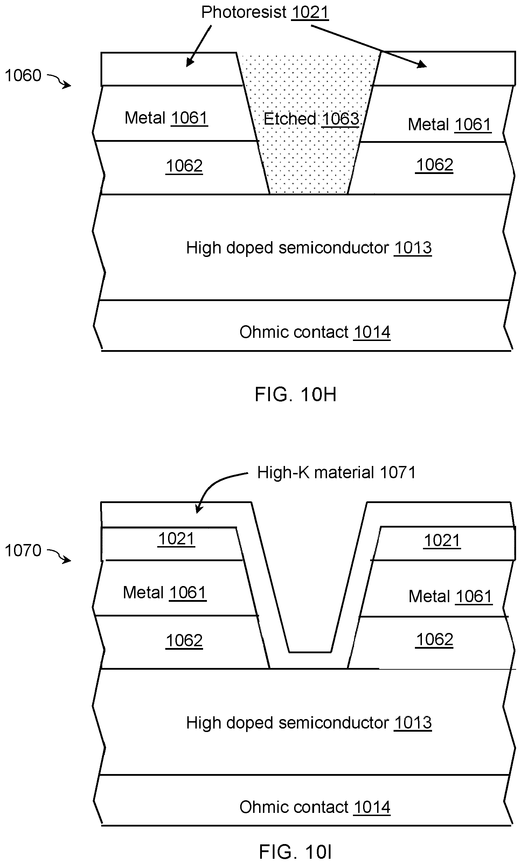

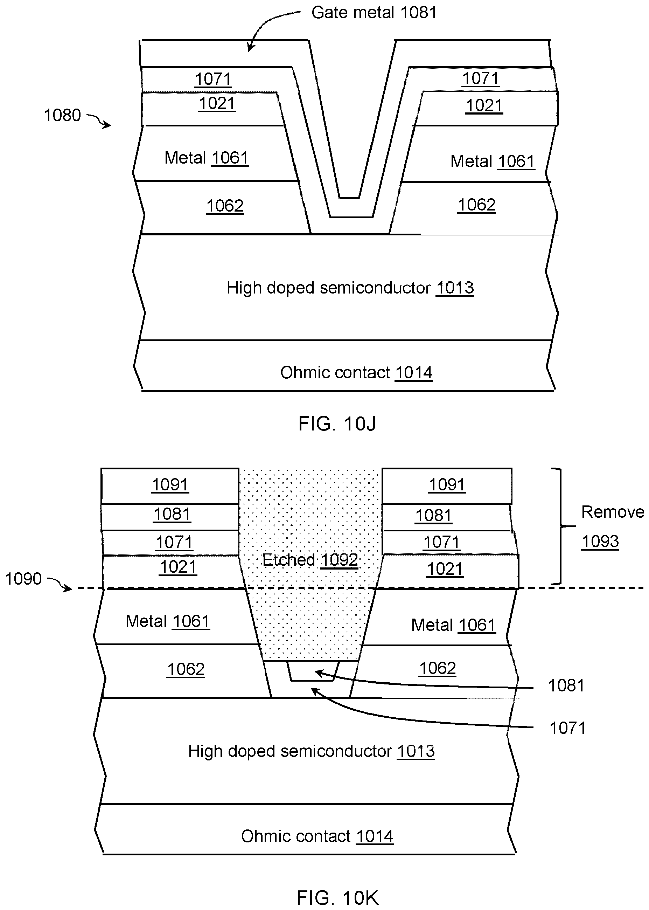

Reference is now made to FIG. 10A, which shows a flowchart 1000 of a method of manufacturing a BM transistor using a single mask, as well as FIGs. 10B-10F, which show cross-section views of examples of a wafer consistent with the steps of method 1000. A wafer may be prepared as at step 1001, which may correspond to wafer 1010 of FIG. 10B. Wafer 1010 may be prepared in step 1001 comprising a metal layer 1011, a low-doped epitaxial layer 1012 (such as an epitaxial layer), a high-doped semiconductor layer 1013, and an ohmic contact 1014. Photolithography of wafer 1010 may be performed as at step 1002, such as to produce a wafer 1020 comprising a photoresist layer 1021 selectively over some parts of metal 1011. Metal 1011 may be etched as at step 1003 to remove the metal layer 1011 in areas where there may be no photoresist 1021, such as etched area 1032, and produce etched metal layer 1031 of wafer 1030. For example, a metal layer 1011 may be etched using a reactive ion etching process. For example, the etching process is configured to etch a recess or trench between metal regions with sloped sides, such as a "V" shaped trench. For example, an anisotropic wet etch may produce a "V" shaped recess or trench. For example, reactive ion etching with sidewall tapering may be used to etch a "V" shaped trench. At step 1004, a high-K dielectric material insulating layer 1041 is deposited over the photoresist 1021 and etched region 1032, as at wafer 1040. For example, advanced directional sputtering (ADS) is used to cover the base and vertical walls of the etched region, where the ADS process uses a relatively large distance between target and substrate (about 1.5 times the substrate diameter). At step 1005, a gate metal layer 1051 may be deposited over the high-K dielectric material insulating layer 1041, as shown in wafer 1050. The top layers of wafer 1050, such as photoresist 1021, parts of high-K material insulating layer 1041, and parts of metal layer 1051 may be removed (such as at step 1006), as may be shown at 1052. For example, top layers may be removed by grinding.

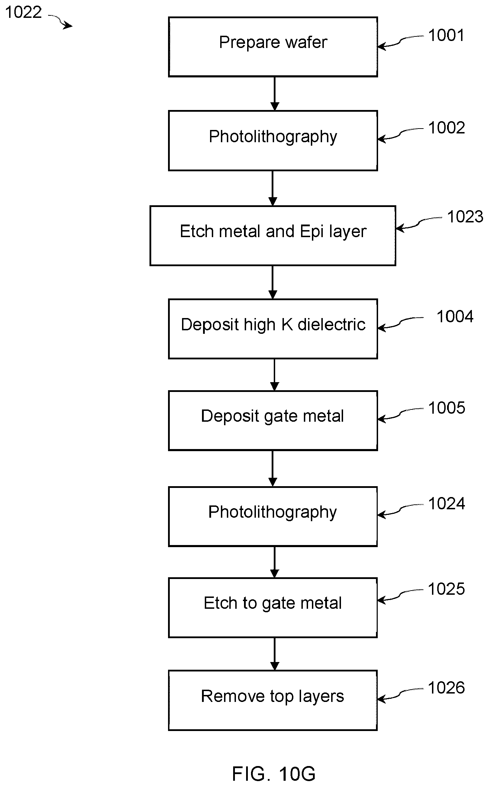

Reference is now made to FIG. 10G, which shows a flowchart 1022 of a method of manufacturing a BM transistor similar to method 1000, as well as FIGs. 10H-10K, which show cross-section views examples of a wafer consistent with the steps of method 1022. A wafer may be prepared as at step 1001, which may correspond to wafer 1010 of FIG. 10B. Wafer 1010 may be prepared in step 1001 comprising a metal layer 1011, a low-doped epitaxial layer 1012 (such as an epitaxial layer), a high-doped semiconductor layer 1013, and an ohmic contact 1014. Photolithography of wafer 1010 may be performed as at step 1002, such as to produce a wafer 1020 comprising a photoresist layer 1021 selectively over some parts of metal 1011. Metal 1011 and low-doped epitaxial layer 1012 may be etched as at step 1023 to remove these layers in areas where there may be no photoresist 1021, such as etched area 1063, and produce etched metal layer 1061 and etched epi layer 1062 of wafer 1060. For example, the etching process is configured to etch a trench between metal regions with sloped sides, such as a "V" shaped trench. At step 1004, a high-K dielectric material insulating layer 1071 is deposited over the photoresist 1021 and etched region 1062, as at wafer 1070. For example, advanced directional sputtering (ADS) is used to cover the base and vertical walls of the etched region, where the ADS process uses a relatively large distance between target and substrate (about 1.5 times the substrate diameter). At step 1005, a gate metal layer 1081 may be deposited over the high-K dielectric material insulating layer 1071, as shown in wafer 1080. A second photoresist mask 1091 may be deposited over the metal layer 1081 as at step 1024 and shown in wafer 1090. The gate metal layer 1081 and the high-K dielectric material insulating layer 1071 may be etched as at step 1025 to remove region 1092, and the top layers of wafer 1090 may be removed from the metal layer 1061 and up, such as at step 1026. For example, top layers may be removed by grinding.

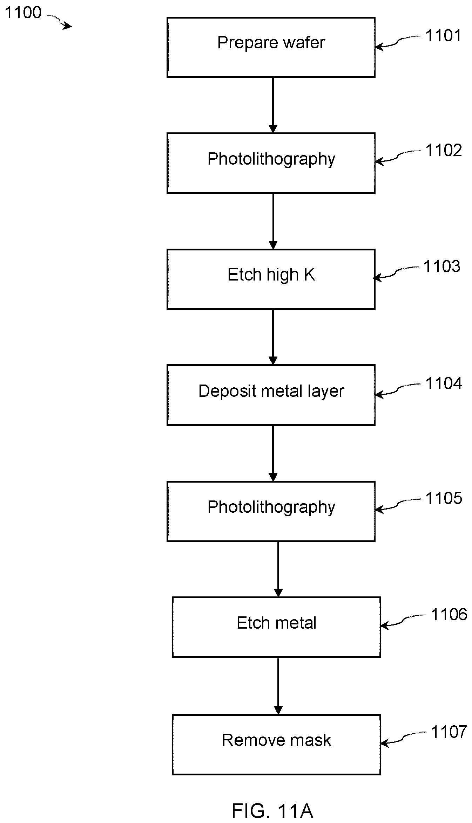

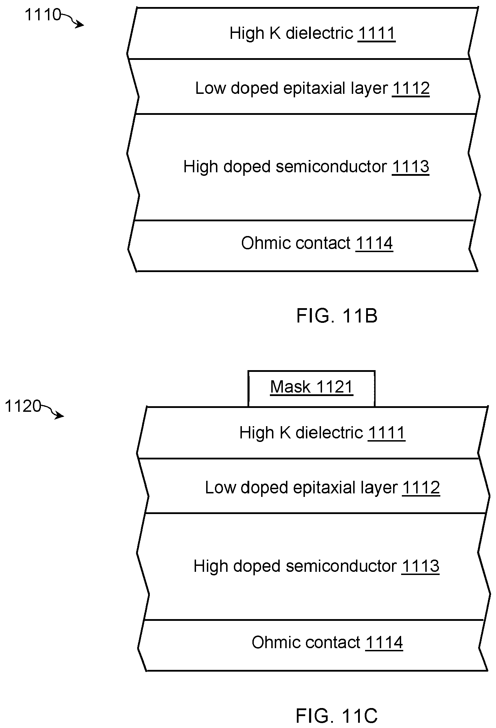

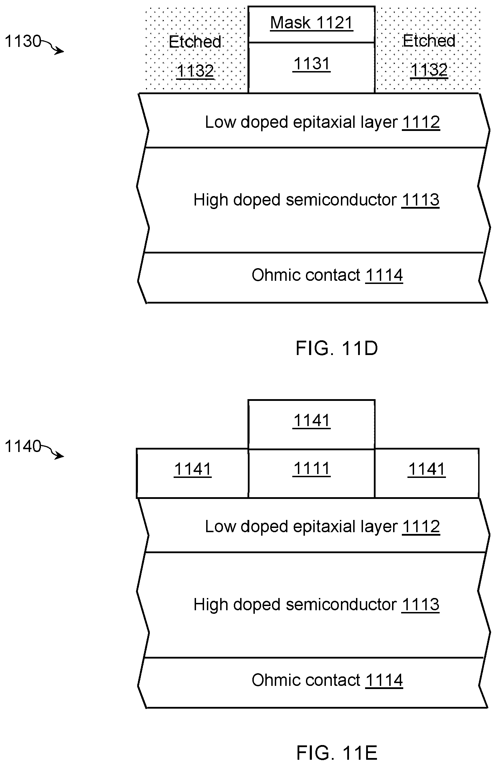

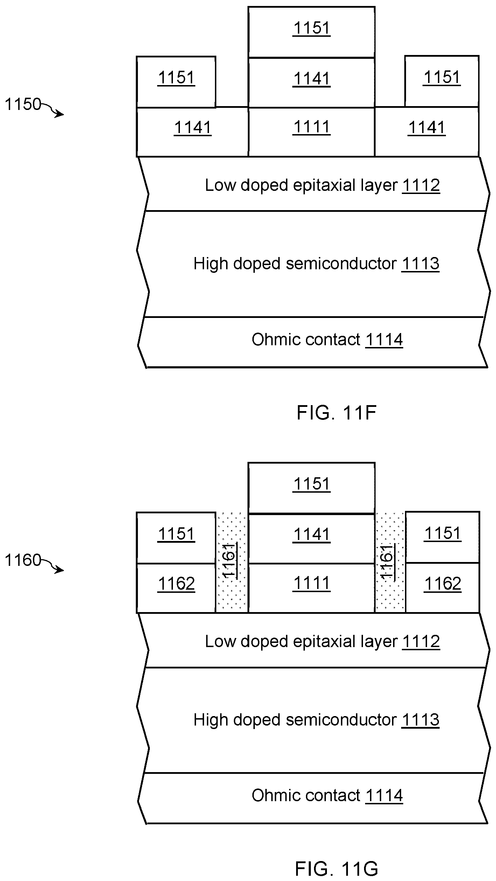

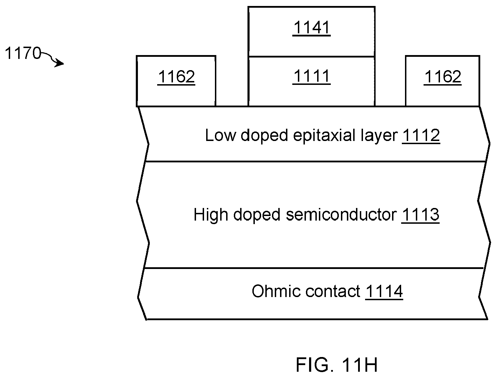

Reference is now made to FIG. 11A, which shows a flowchart 1100 of a method of manufacturing a BM transistor using a single mask, as well as FIGs. 11B-11H, which show cross-section views examples of a wafer consistent with the steps of method 1100. A wafer may be prepared as at step 1101, which may correspond to wafer 1110 of FIG. 11B. Wafer 1110 may be prepared in step 1101 comprising a high-K dielectric insulating layer 1111, a low-doped epitaxial layer 1112 (such as an epitaxial layer), a high-doped semiconductor layer 1113, and an ohmic contact 1114. Photolithography of wafer 1110 may be performed as at step 1102, such as to produce a wafer 1120 comprising a photoresist layer 1121 selectively over some parts of high-K dielectric insulating layer 1111. High-K dielectric insulating layer 1111 may be etched as at step 1103 to remove the high-K dielectric insulating layer 1111 in areas where there may be no photoresist 1121, such as etched area 1132, and produce etched high-K dielectric insulating layer 1131 of wafer 1130. For example, the etching process is configured to etch a recess or trench between metal regions with sloped sides, such as a "V" shaped trench. At step 1103 the photoresist may be removed. At step 1104, a metal layer 1141 may be deposited over the etched high-K dielectric insulating layer 1131 and epi layer 1112, as at wafer 1140. At step 1105, a photoresist 1151 may be deposited over part of the metal layer 1141, as shown in wafer 1150. At step 1106, the metal layer 1141 may be removed where no photoresist 1151 exists as in wafer 1160, such as regions 11161, producing etched metal layer 1162. The photoresist 1151 may be removed (such as at step 1107), as shown in wafer 1170.

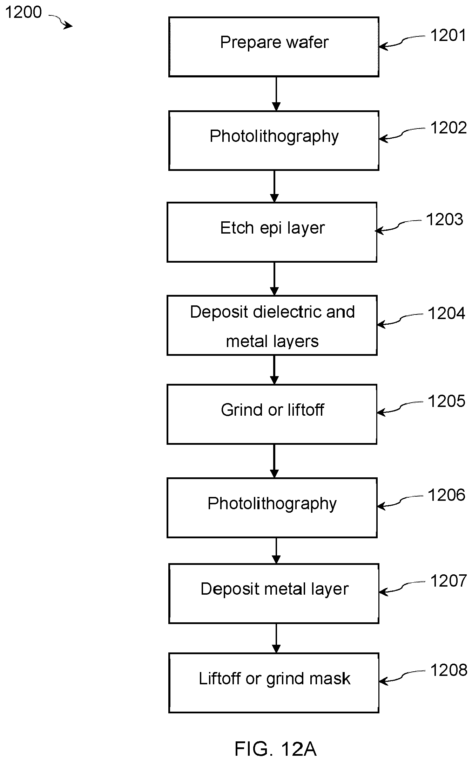

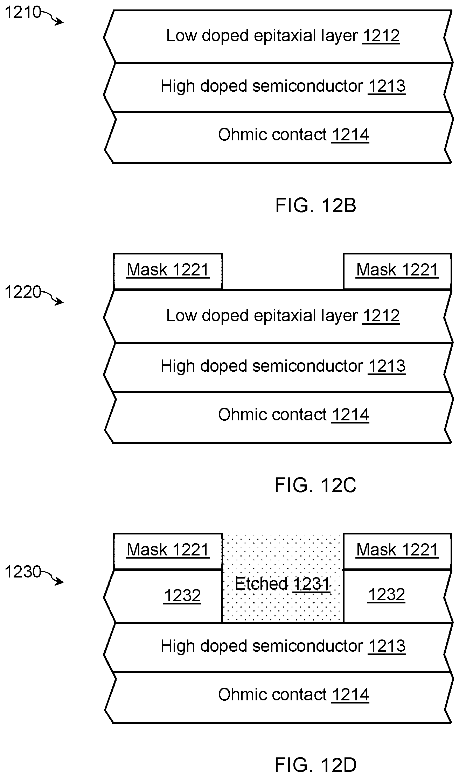

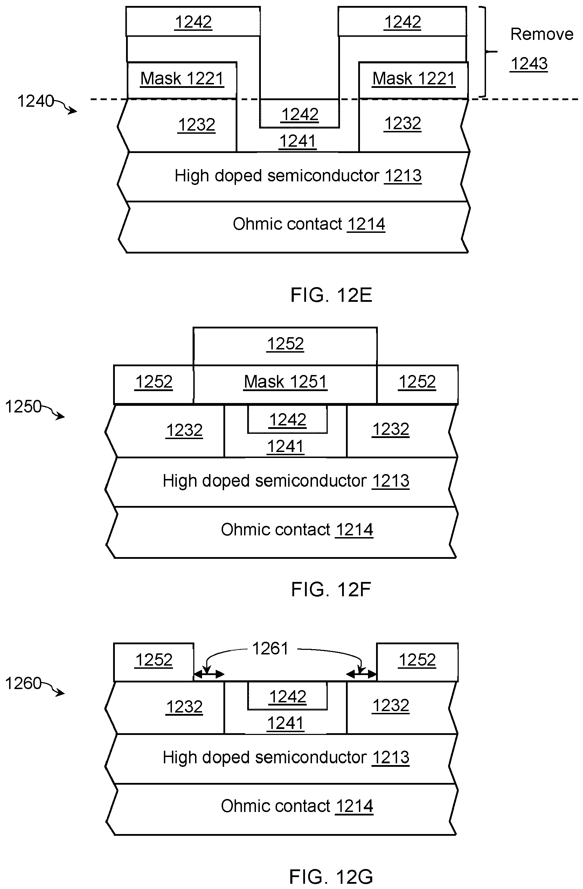

Reference is now made to FIG. 12A, which shows a flowchart 1200 of a method of manufacturing a BM transistor using a single mask, as well as FIGs. 12B-12G, which show cross-section views examples of a wafer consistent with the steps of method 1200. A wafer may be prepared as at step 1201, which may correspond to wafer 1210 of FIG. 10B.

Wafer 1210 may be prepared in step 1201 comprising a low-doped epitaxial layer 1212 (such as an epitaxial layer, or epi layer), a high-doped semiconductor layer 1213, and an ohmic contact 1214. Photolithography of wafer 1210 may be performed as at step 1202, such as to produce a wafer 1220 comprising a photoresist layer (mask) 1221 selectively over some parts of epi layer 1212. Epi layer 1212 may be etched as at step 1203 to remove the epi layer 1212 in areas where there may be no photoresist 1221, such as etched area 1231, and produce etched epi layer 1231 of wafer 1230. At step 1203 mask 1221 may be removed. At step 1204, a high-K dielectric material insulating layer 1241 and a gate metal layer 1242 are deposited over the high-doped semiconductor layer 1213 and mask 1221, as at wafer 1240. For example, advanced directional sputtering (ADS) may be used to cover the base and vertical walls of the etched region. Other deposition processes may be used as disclosed hereinabove. At step 1205, mask 1221 and parts of high-K dielectric material insulating layer 1241 and gate metal layer 1242 may be removed as shown in wafer 1240, such as by grinding or liftoff. Photoresist 1251 and barrier metal layer 1252 may be deposited (as at steps 1206 and 1207), as shown in wafer 1250. The photoresist 1251 may be removed (such as at step 1208), as may be shown at wafer 1260, thereby producing a configurable separation 1261 between the barrier metal 1252 and the high-K dielectric insulating layer 1241. For example, the distance along the semiconductor substrate epi layer 1232 between the SB edge of the metal layer 1252 and the gate electrode 1242 may be configured to be between 0.1 micrometer and 30 micrometers. For example, the distance 1261 may be 0.1 micrometers. For example, the distance 1261 may be 0.5 micrometers. For example, the distance 1261 may be 1 micrometer. For example, the distance 1261 may be 2 micrometer. For example, the distance 1261 may be 4 micrometers. For example, the distance 1261 may be 8 micrometers. For example, the distance 1261 may be 15 micrometers. For example, the distance 1261 may be 30 micrometer. For example, the distance 1261 may be between 0.1 and 1 micrometers. For example, the distance 1261 may be between 1 and 5 micrometers. For example, the distance 1261 may be between 1 and 10 micrometers. For example, the distance 1261 may be between 5 and 10 micrometers. For example, the distance 1261 may be between 0.5 and 5 micrometers. For example, the distance 1261 may be between 5 and 30 micrometers. For example, the distance 1261 may be between 10 and 30 micrometers. By adjusting the distance 1261 to a small value, the leakage current may be reduced, and by adjusting to a large value more control may be enabled by the gate electrode over the depletion region surrounding the edge.

The figures described herein show schematically the materials and processes used to manufacture the devices. The schematic objects are not to scale in the figures, and thicknesses of each layer object may be determined based on the specifications of the device that is to be manufactured. For example, the specified breakdown voltage of the device may determine the thicknesses and geometries of the different components of the device. For example, the distance between the barrier metal region and the gate electrode may be determined by the layer thicknesses of the prepared wafer, the specified breakdown voltage, the amount and type of undercut configured, and the normal operating voltage and current. For example, the metal layer may have a thickness of at least 2 nanometer. For example, the gate electrode may have a thickness of at least 2 nanometer. Metal and insulation layers may be configured to provide a mechanical and electrical continuity, such as being at least 5 atoms (or at least 3 unit cells in the case of crystal structures) thick.

The process of FIGs. 8A, 10A, 10G, 11A, and 12A may be enhanced by applying a second photolithography step to improve the device performance or edge density. For example, a second photolithography step may be used to limit the gate electrode locations and sizes, configured to produce the devices of FIGs. 3A-3D, 5A-5B, and 6A-6E. For example, a second photolithography step may be used to configure the gate electrode locations and sizes to be no more than 1 to 100 micrometers distant from the metal region, thus saving gate electrode material. For example, a second photolithography step may be used to configure the busbars and insulators of FIGs. 3A-3D. For example, a second photolithography step may be used to configure the busbars of FIGs. 3A-3D as air bridges. Other configurations of devices can be produced by adding a second photolithography step that may be beneficial.

The process of FIGs. 8A, 10A, 10G, 11A, and 12A may be enhanced by applying more photolithography steps to improve the device performance or value. For example, further photolithography steps may be used to limit the gate electrode locations and sizes, configured to produce the devices of FIGs. 3A-3D, 5A-5B, and 6A-6E. For example, more photolithography steps may be used to configure the gate electrode locations and sizes to be no more than 1 to 100 micrometers distant from the metal region, thus saving gate electrode material. For example, more photolithography steps may be used to configure the busbars and insulators of FIGs. 3A-3D. For example, more photolithography steps may be used to configure the busbars of FIGs. 3A-3D as air bridges. Other configurations of devices may be produced by adding more photolithography steps that may be beneficial.

Methods for manufacturing wafers containing BM transistors (such as 800, 1000, 1020, 1100, and 1200) may be enhanced by applying another photolithography step to improve the device performance or value. For example, a second photolithography step may be used to limit the gate electrode locations and sizes, configured to produce the devices of FIGs. 3A-3D, 5A-5B, and 6A-6E. For example, a second photolithography step may be used to configure the gate electrode locations and sizes to be no more than 0.1 to 30 micrometers distant from the metal region, thus saving gate electrode material. For example, a second photolithography step may be used to configure the busbars and insulators of FIGs. 3A-3D. For example, a second photolithography step may be used to configure the busbars of FIGs. 3A-3D as air bridges. Other configurations of devices may be produced by adding a second photolithography step that may be beneficial.

Methods for manufacturing wafers containing BM transistors (such as 800, 1000, 1020, 1100, and 1200) may be enhanced by applying more photolithography steps to improve the device performance or value. For example, more photolithography step may be used to limit the gate electrode locations and sizes, configured to produce the devices of FIGs. 3A-3D, 5A-5B, and 6A-6E. For example, more photolithography step may be used to configure the gate electrode locations and sizes to be no more than 1 to 100 micrometers distant from the metal region, thus saving gate electrode material. For example, more photolithography steps may be used to configure the busbars and insulators of FIGs. 3A-3D. For example, more photolithography step may be used to configure the busbars of FIGs. 3A-3D as air bridges. Other configurations of devices may be produced by adding more photolithography step that may be beneficial.

A controller, such as an electronic component configured to execute instructions, may be used to execute a method of operation of a BM transistor. For example, a controller may be a central processing unit, a micro-processor, a controller, an embedded control, a digital hard-wired logic circuit, an application specific instruction set processor, an application specific integrated circuit, a multi-core processor, a field programmable gate array (FPGA), or the like. Instructions may be stored in memory (such as hardware-based digital storage) accessible by the controller, stored as software in a repository, hardwired in digital logic or an FPGA, and/or the like. A gate driver voltage/current profile may be configured to control the operation of the device, such as the voltage/current between the metal and semiconductor.

Here, as elsewhere in the specification and claims, numerical ranges may be combined to form larger numerical ranges.

Specific dimensions, specific materials, specific ranges, specific resistivities, specific voltages, specific shapes, specific currents, and/or other specific properties and values disclosed herein are example in nature and do not limit the scope of the present disclosure. The disclosure herein of particular values and particular ranges of values for given parameters are not exclusive of other values and ranges of values that may be useful in one or more of the examples disclosed herein. Moreover, it may be envisioned that any two particular values for a specific parameter stated herein may define the endpoints of a range of values that may be suitable for the given parameter (for example, the disclosure of a first value and a second value for a given parameter may be interpreted as disclosing that any value between the first and second values may also be employed for the given parameter). For example, when Parameter X is exemplified herein to have value A and also exemplified to have value Z, it may be envisioned that parameter X may have a range of values from about A to about Z. Similarly, it may be envisioned that disclosure of two or more ranges of values for a parameter (whether such ranges are nested, overlapping or distinct) subsume all possible combination of ranges for the value that might be claimed using endpoints of the disclosed ranges. For example, when parameter X is exemplified herein to have values in the range of 1-10, or 2-9, or 3-8, it may also be envisioned that Parameter X may have other ranges of values including 1-9, 1-8, 1-3, 1-2, 2-10, 2-8, 2-3, 3-10, and 3-9.

An apparatus may comprise a semiconductor substrate; a metal layer partially covering the semiconductor substrate thereby forming a Schottky barrier, wherein the metal layer may comprise an edge at a periphery of the metal layer, wherein the edge may contact the semiconductor substrate; and a gate electrode adjacent to the edge, wherein the gate electrode may be insulated from the metal layer and the semiconductor substrate. The gate electrode adjacent to the edge may comprise an acute cross-section angle. The edge adjacent to the gate electrode may comprise an acute cross-section angle. The metal layer may comprise a plurality of metal structures forming a plurality of edges, wherein the plurality of metal structures may be interconnected with a plurality of metal busbars. The metal layer may comprise a plurality of metal structures forming a plurality of edges, wherein the gate electrode may comprise a plurality of gate electrode structures, wherein each of the plurality of gate electrode structures may be adjacent to one of the plurality of metal structures. The plurality of gate electrode structures may be interconnected with a plurality of gate busbars. The semiconductor substrate may comprise a n-type dopant, and when a gate voltage of the gate electrode is set to a voltage higher than a barrier voltage of the metal layer, a reverse bias current may flow from an ohmic contact of the semiconductor substrate to the metal layer. The gate electrode may be insulated from the metal layer with a material comprising a dielectric constant less than 3.0, a material with a breakdown strength greater than 10 kV/cm, or an air gap. The gate electrode may be insulated from the semiconductor substrate with a material comprising a dielectric constant greater than 3.5 and a breakdown strength greater than 10 kV/cm. A voltage applied to the gate electrode may be configured to increase a flow of current in a reverse bias direction of the Schottky barrier.

An apparatus may comprise a Schottky barrier having a semiconductor substrate at a first voltage and a metal layer at a second voltage, wherein the metal layer partially covers the semiconductor substrate, the metal layer comprises an edge at a periphery of the metal layer, and the edge is located on the semiconductor substrate, and a reverse bias voltage applied to the Schottky barrier. The apparatus may further comprise a gate electrode, wherein the gate electrode is adjacent to and insulated from the edge and the semiconductor substrate, thereby increasing a flow of current in a reverse bias direction, and a third voltage applied to the gate electrode. The gate electrode and the metal layer may be separated by a first insulating layer and/or a second insulating layer between the gate electrode and the metal layer. The first insulating layers may comprise a material with a high breakdown strength, a material with a low breakdown strength, or an air gap. The second insulating layers may comprise a material with a high relative permittivity and a high breakdown strength. The metal layer may form one or more comb-shaped structures configured to increase a length of the edge for a given area of the semiconductor substrate. The metal layer may comprise segments configured to increase a length of the edge for a given area of the semiconductor substrate, wherein the segments may have a shape comprising at least one of a line segment, a curved segment, a circular structure, or a perforation. The semiconductor substrate may comprise an n-type semiconductor material, wherein the first voltage of the semiconductor substrate is greater than the second voltage of the metal layer, wherein the third voltage of the gate electrode is greater than the second voltage of the metal layer, and wherein the flow of current from the semiconductor substrate to the metal layer may be responsive to the second voltage. The third voltage may be greater than the first voltage.

In the description of various illustrative features, reference is made to the accompanying drawings, which form a part hereof, and in which is shown, by way of illustration, various features in which the disclosure may be practiced. It may be to be understood that other features may be utilized and structural and functional modifications may be made, without departing from the scope of the present disclosure.

It may be noted that various connections are set forth between elements herein. These connections are described in general and, unless specified otherwise, may be direct or indirect; this specification is not intended to be limiting in this respect, and both direct and indirect connections may be envisioned. Further, elements of one feature in any of the examples may be combined with elements from other features in any of the examples, in any combinations or sub-combinations. For example, a cascade of transistors may be used to implement multiple levels of driving strength, some levels comprising digital control as at 530 and other levels comprising analog controls as at 560.

Although examples are described above, all features and/or steps of those examples may be combined, divided, omitted, rearranged, revised, and/or augmented in any desired manner. Various alterations, modifications, and improvements will readily occur to those skilled in the art. Such alterations, modifications, and improvements are intended to be part of this description, though not expressly stated herein, and are intended to be within the spirit and scope of the descriptions herein. Accordingly, the foregoing description is by way of example only, and is not limiting.

Hereinafter, various characteristics will be highlighted in a set of numbered clauses or paragraphs. These characteristics are not to be interpreted as being limiting on the invention or inventive concept, but are provided merely as a highlighting of some characteristics as described herein, without suggesting a particular order of importance or relevancy of such characteristics

Clause 1. An apparatus, comprising:

a semiconductor substrate;
a metal layer partially covering the semiconductor substrate, wherein the metal layer comprises an edge at the periphery of the metal layer, wherein the edge contacts the semiconductor substrate; and
a gate electrode adjacent to the edge, wherein the gate is insulated from the metal layer by a first insulating layer, and wherein the gate is insulated from the semiconductor substrate by a second insulating layer.

Clause 2. The apparatus of clause 1, wherein the semiconductor substrate and the metal layer form a Schottky barrier.

Clause 3. The apparatus of any one of clauses 1 to 2, wherein the first insulating layer is an air gap.

Clause 4. The apparatus of any one of clauses 1 to 2, wherein the first and second insulating layers comprise a material with a dielectric strength greater than 10 kV/cm.

Clause 5. The apparatus of any one of clauses 1 to 2, wherein the first and second insulating layers comprise a material with a dielectric constant greater than 3.5 and a dielectric strength greater than 10 kV/cm.

Clause 6. The apparatus of any one of clauses 1 to 2, wherein the first and second insulating layers comprise a material with a dielectric constant greater than 3.5.

Clause 7. The apparatus of any one of clauses 1 to 2, wherein the first insulating layer comprises a material with a dielectric constant less than 3.0.

Clause 8. The apparatus of any one of clauses 1 to 2, wherein the first insulating layer comprises a material with a low-K dielectric constant.

Clause 9. The apparatus of any one of clauses 1 to 2, wherein the second insulating layer comprises a material with a high dielectric constant and a high dielectric strength.

Clause 10. The apparatus of any one of clauses 1 to 2, wherein the second insulating layer comprises a material with a dielectric constant greater than 3.5.

Clause 11. The apparatus of any one of clauses 1 to 2, wherein the second insulating layer comprises a material with a dielectric strength greater than 10 kV/cm.

Clause 12. The apparatus of any one of clauses 1 to 2, wherein the second insulating layer comprises a material with a high dielectric constant.

Clause 13. The apparatus of any one of clauses 1 to 12, wherein the metal layer forms one or more finger structures covering the semiconductor substrate configured to increase a length of the edge for a given area of the semiconductor substrate.

Clause 14. The apparatus of any one of clauses 1 to 12, wherein the metal layer comprises structures covering the semiconductor substrate configured to increase a length of the edge for a given area of the semiconductor substrate, wherein the structures each have a shape comprising at least one of a line segment, a curved segment, a circular structures, or a perforation.

Clause 15. The apparatus of any one of clauses 1 to 14, wherein the metal layer comprises a plurality of metal layer structures in contact with the semiconductor substrate, and wherein the plurality of metal contact structures are interconnected.

Clause 16. The apparatus of clause 15, wherein the gate electrode comprises a plurality of gate electrode structures, wherein each of the plurality of metal contact structures is coaxial with one of the plurality of gate electrode structures.

Clause 17. The apparatus of clause 15, wherein the gate electrode comprises a plurality of gate electrode structures, wherein each of the plurality of metal layer structures is coaxial with one of the plurality of gate electrode structures, and wherein each of the plurality of gate electrode structures comprises a shape that follows a second edge of the plurality of metal layer structures.

Clause 18. The apparatus of clause 15, wherein the plurality of metal layer structures are arranged in a pattern on the semiconductor substrate.

Clause 19. The apparatus of clause 15, wherein each of the plurality of metal layer structures is circular-shaped, hexagonal-shaped, square-shaped, rectangle-shaped, or triangle-shaped.

Clause 20. The apparatus of clause 15, wherein the gate electrode comprises a plurality of gate electrode structures, wherein each of the plurality of gate electrode structures surrounds one of the plurality of metal layer structures.

Clause 21. The apparatus of clause 15, wherein the gate electrode comprises a plurality of gate electrode structures, wherein each of the plurality of gate electrode structures is adjacent to a second edge of one of the plurality of metal layer structures.

Clause 22. The apparatus of clause 15, wherein the gate electrode comprises a plurality of gate electrode structures, wherein each of the plurality of gate electrode structures are configured to increase a charge density at a second edge of each of the plurality of metal layer structures.

Clause 23. The apparatus of any one of clauses 1 to 22, wherein the gate electrode is located above the edge.

Clause 24. The apparatus of any one of clauses 1 to 22, wherein the gate electrode is located above the metal layer.

Clause 25. The apparatus of any one of clauses 1 to 22, wherein the gate electrode is located adjacent to and above the metal layer, such that the gate electrode is located over the semiconductor substrate adjacent to the metal layer.

Clause 26. The apparatus of any one of clauses 1 to 22, wherein the edge comprises an acute angle in cross-section.

Clause 27. The apparatus of any one of clauses 1 to 22, wherein the gate electrode comprises an acute angle in cross-section, and wherein the acute angle is directed toward the edge.

Clause 28. The apparatus of any one of clauses 1 to 22, wherein the gate electrode is located at a distance from 0.1 to 30 micrometers from the edge.

Clause 29. The apparatus of any one of clauses 1 to 22, wherein the gate electrode is located above the metal layer, wherein the gate electrode is located above only part of the metal layer, and wherein the gate is located within a distance from the edge.

Clause 30. The apparatus of any one of clauses 1 to 29, wherein the semiconductor substrate comprises an n-type semiconductor material, wherein a first voltage of the semiconductor is greater than a second voltage of the metal layer, wherein a third voltage of the gate electrode is greater than the second voltage, and wherein the current from the semiconductor substrate to the metal layer is responsive to the third voltage.

Clause 31. The apparatus of clause 30, wherein the third voltage is greater than the first voltage.

Clause 32. The apparatus of any one of clauses 1 to 29, wherein the semiconductor substrate comprises a p-type semiconductor material, wherein a first voltage of the semiconductor substrate is less than a second voltage of the metal layer, wherein a third voltage of the gate is less than the second voltage, and wherein the current from the metal layer to the semiconductor substrate is responsive to the third voltage.

Clause 33. The apparatus of clause 32, wherein the third voltage is less than the first voltage.

Clause 34. The apparatus of any one of clauses 1 to 33, wherein the third voltage configures the apparatus as a switch, and wherein the gate electrode is operated between an on state and an off state.

Clause 35. The apparatus of any one of clauses 1 to 33, wherein the third voltage configures the apparatus as an amplifier, and wherein the gate electrode is operated in a linear mode.

Clause 36. The apparatus of any one of clauses 1 to 35, wherein the semiconductor substrate comprises a high-doped semiconductor layer.

Clause 37. The apparatus of any one of clauses 1 to 36, wherein the semiconductor substrate comprises a low-doped epitaxial layer.

Clause 38. A method comprising:

applying a reverse bias voltage to a Schottky barrier, wherein the Schottky barrier comprises a semiconductor substrate at a first voltage and a metal layer at a second voltage, wherein the metal layer partially covers the semiconductor substrate, wherein the metal layer comprises an edge at the periphery of the metal layer, wherein the edge is located on the semiconductor substrate;
applying a third voltage to a gate electrode, wherein the gate electrode is adjacent to and insulated from the edge and the semiconductor substrate, thereby increasing a flow of current in a reverse bias direction.

Clause 39. The method of clause 38, further comprising a first insulating layer between the gate electrode and the metal layer.

Clause 40. The method of any one of clauses 38 to 39, further comprising a second insulating layer between the gate electrode and the semiconductor substrate.

Clause 41. The method of clause 39, wherein the first insulating layers comprise a material with a breakdown strength greater than 10 kV/cm, a material with a dielectric constant less than 3.0, or an air gap.

Clause 42. The method of clause 40, wherein the second insulating layers comprise a material with a dielectric constant greater than 3.5 and a breakdown strength greater than 10 kV/cm.

Clause 43. The method of any one of clauses 38 to 42, wherein the metal layer forms one or more comb-shaped structures configured to increase a length of the edge for a given area of semiconductor substrate.

Clause 44. The method of any one of clauses 38 to 43, wherein the metal layer comprises segments configured to increase a length of the edge for a given area of the semiconductor substrate, wherein the segments have a shape comprising at least one of a line segment, a curved segment, a circular structure, or a perforation.

Clause 45. The method of any one of clauses 38 to 44, wherein the semiconductor substrate comprises an n-type semiconductor material, wherein the first voltage of the semiconductor substrate is greater than the second voltage of the metal layer, wherein the third voltage of the gate is greater than the second voltage, and wherein the current from the semiconductor substrate to the metal layer is responsive to the third voltage.

Clause 46. The method of clause 45, wherein the third voltage is greater than the first voltage.

Clause 47. The method of any one of clauses 38 to 44, wherein the semiconductor substrate comprises a p-type semiconductor material, wherein the first voltage of the semiconductor substrate is less than the second voltage of the metal layer, wherein the third voltage of the gate is less than the second voltage, and wherein the current from the metal layer to the semiconductor substrate is responsive to the third voltage.

Clause 48. The method of clause 47, wherein the third voltage is less than the first voltage.

Clause 49. A device comprising the apparatus of any one of clauses 1 to 37.

Clause 50a. A power converter comprising the apparatus of any one of clauses 1 to 37.

Clause 50b. A device performing the method of any one of clauses 38 to 48.

Clause 51. A power converter performing the method of any one of clauses 38 to 48.

Clause 52. A method of manufacturing a transistor, comprising:

preparing a wafer, wherein the wafer comprises an ohmic contact layer, a high doped semiconductor layer, a low doped semiconductor layer, a dielectric material layer, and a gate metal layer;
applying a photoresist layer using a photolithographic mask;
etching the gate metal layer;
etching the dielectric material layer;
depositing a barrier metal layer; and
removing the photoresist layer and at barrier metal layer in contact with the photoresist layer.

Clause 53. The method of clause 52, wherein the dielectric material layer comprises a material with a dielectric strength greater than 10 kV/cm and a dielectric constant greater than 3.5.

Clause 54. The method of any one of clauses 52 to 53, further comprising a step of etching the dielectric material layer prior to depositing the barrier metal layer, wherein the etching of the dielectric material layer is configured to create an undercut.

Clause 55. The method of any one of clauses 52 to 54, wherein the etching of the gate metal layer is configured to produce a tapered cross-section.

Clause 56. The method of any one of clauses 52 to 55, wherein the etching of the dielectric material layer is configured to produce a tapered cross-section.

Clause 57. The method of any one of clauses 52 to 56, wherein the dry etching process comprises at least one of reactive ion etching, plasma etching, physical removal, ion milling, sputter etching, and deep ion etching.

Clause 58. The method of any one of clauses 54 to 57, wherein the undercut is performed with a wet etching process.

Clause 59. The method of any one of clauses 54 to 58, wherein the undercut and the etching of the dielectric material layer are performed in a single etching process.

Clause 60. A method of manufacturing a transistor, comprising:

preparing a wafer, wherein the wafer comprises an ohmic contact layer, a high doped semiconductor layer, a low doped semiconductor layer, and a barrier metal layer;

applying a photoresist layer using a photolithographic mask;

etching the barrier metal layer;

depositing a dielectric material layer;

depositing a gate metal layer; and

removing the photoresist layer, part of the dielectric material layer, and part of the gate metal layer.

Clause 61. The method of clause 60, wherein the dielectric material layer comprises a material with a dielectric strength greater than 10 kV/cm and a dielectric constant greater than 3.5.

Clause 62. The method of clause 60, wherein the etching of the barrier metal layer is configured to produce a tapered cross-section.

Clause 63. A method of manufacturing a transistor, comprising:

preparing a wafer, wherein the wafer comprises an ohmic contact layer, a high-doped semiconductor layer, a low-doped semiconductor layer, and a metal layer;

applying a photoresist layer using a photolithographic mask;

etching the barrier metal layer and at least part of the low-doped semiconductor layer;

depositing a dielectric material layer;

depositing a gate metal layer; and

removing the photoresist layer, part of the dielectric material layer, and part of the gate metal layer.

Clause 64. The method of clause 63, wherein the dielectric material layer comprises a material with a dielectric strength greater than 10 kV/cm and a dielectric constant greater than 3.5.

Clause 65. The method of clause 63, wherein the etching of the barrier metal layer and at least part of the low-doped semiconductor layer is configured to produce a tapered cross-section.

Clause 66. A method of manufacturing a transistor, comprising:

preparing a wafer, wherein the wafer comprises an ohmic contact layer, a high-doped semiconductor layer, a low-doped semiconductor layer, and an insulating layer;

applying a first photoresist layer using a first photolithographic mask;

etching at least part of the insulating layer;

removing the first photoresist layer;

depositing a metal layer;

applying a second photoresist layer using a second photolithographic mask;

etching at least part of the metal layer; and

removing the second photoresist layer.

Clause 66b. The method of clause 66, wherein the insulating layer comprises a material with a dielectric strength greater than 10 kV/cm and a dielectric constant greater than 3.5.

Clause 67. A method of manufacturing a transistor, comprising:

preparing a wafer, wherein the wafer comprises an ohmic contact layer, a high-doped semiconductor layer, a low-doped semiconductor layer, and an insulating layer;

applying a first photoresist layer using a first photolithographic mask;

etching at least part of the insulating layer;

removing the first photoresist layer;

depositing a metal layer;

applying a second photoresist layer using a second photolithographic mask;

etching at least part of the metal layer; and

removing the second photoresist layer.

Clause 67b. The method of clause 67, wherein the insulating layer comprises a material with a dielectric strength greater than 10 kV/cm and a dielectric constant greater than 3.5.

Clause 68. An apparatus, comprising:

a semiconductor substrate;
a metal layer partially covering the semiconductor substrate thereby forming a Schottky barrier (SB), wherein the metal layer comprises an edge at the periphery of the metal layer, wherein the edge contacts the semiconductor substrate; and
a gate electrode adjacent to the edge, wherein the gate is insulated from the metal layer, wherein the gate is insulated from the semiconductor substrate.

Clause 69. The apparatus of clause 68, wherein the gate electrode adjacent to the edge comprises an acute cross-section angle.

Clause 70. The apparatus of any one of clauses 68 to 69, wherein the edge adjacent to the gate electrode comprises an acute cross-section angle.

Clause 71. The apparatus of any one of clauses 68 to 70, wherein the metal layer comprises a plurality of metal structures forming a plurality of edges.

Clause 72. The apparatus of clause 71, wherein the plurality of metal structures are interconnected with a plurality of metal busbars.

Clause 73. The apparatus of clause 71, wherein the gate electrode comprises a plurality of gate electrode structures, wherein each of the plurality of gate electrode structures is adjacent to one of the plurality of metal structures.

Clause 74. The apparatus of clause 73, wherein the plurality of gate electrode structures are interconnected with a plurality of gate busbars.

Clause 75. The apparatus of any one of clauses 68 to 74, wherein the semiconductor substrate comprises a n-type dopant, and when a gate voltage of the gate electrode is set to a high voltage relative to a barrier voltage of the metal layer, a reverse bias current will flow from an ohmic contact of the semiconductor substrate to the metal layer.

Clause 76. The apparatus of any one of clauses 68 to 75, wherein the gate is insulated from the metal layer with a low-K dielectric material, a high-K dielectric material, or an air gap.

Clause 77. The apparatus of any one of clauses 68 to 76, wherein the gate is insulated from the semiconductor substrate with a high-k dielectric material.

Clause 78. The apparatus of any one of clauses 68 to 77, wherein the gate is between 0.1 and 30 micrometers ($\mu$m) from the edge.

Clause 79. The apparatus of any one of clauses 68 to 77, wherein the gate is between 0.2 and 20 $\mu$m from the edge.

Clause 80. The apparatus of any one of clauses 68 to 77, wherein the gate is between 0.4 and 15 $\mu$m from the edge.

Clause 81. The apparatus of any one of clauses 68 to 77, wherein the gate is between 0.5 and 10 $\mu$m from the edge.

Clause 82. The apparatus of any one of clauses 68 to 77, wherein the gate is between 0.5 and 10 $\mu$m from the edge.

Clause 83. The apparatus of any one of clauses 68 to 82, wherein the semiconductor substrate comprises an epitaxial layer, wherein the contact between the epitaxial layer and the metal layer forms the SB, wherein the gate is embedded in the epitaxial layer, and wherein gate is isolated from the epitaxial layer.

Clause 84. The apparatus of any one of clauses 68 to 82, wherein the semiconductor substrate comprises an epitaxial layer, wherein the contact between the epitaxial layer and the metal layer forms the SB, wherein the gate is on top of the epitaxial layer, and wherein gate is isolated from the epitaxial layer.

Clause 85. The apparatus of any one of clauses 68 to 84, wherein the semiconductor substrate comprises an n-type semiconductor material or a p-type semiconductor material.

Clause 86. The apparatus of any one of clauses 68 to 85, wherein the gate electrode comprises a whisker directed towards the edge.

Clause 87. The apparatus of any one of clauses 68 to 86, wherein a voltage applied to the gate electrode is configured to increase a flow of current in a reverse bias direction of the SB.

**Claims**

1. An apparatus, comprising:

   a semiconductor substrate;
   a metal layer partially covering the semiconductor substrate thereby forming a Schottky barrier, wherein the metal layer comprises an edge at a periphery of the metal layer, wherein the edge contacts the semiconductor substrate; and
   a gate electrode adjacent to the edge, wherein the gate electrode is insulated from the metal layer and the semiconductor substrate.

2. The apparatus of claim 1, wherein the gate electrode adjacent to the edge comprises an acute cross-section angle.

3. The apparatus of any one of the preceding claims, wherein the edge adjacent to the gate electrode comprises an acute cross-section angle.

4. The apparatus of any one of the preceding claims, wherein the metal layer comprises a plurality of metal structures forming a plurality of edges.

5. The apparatus of claim 4, wherein the plurality of metal structures are interconnected with a plurality of metal busbars.

6. The apparatus of claim 4, wherein the gate electrode comprises a plurality of gate electrode structures, wherein each of the plurality of gate electrode structures is adjacent to one of the plurality of metal structures.

7. The apparatus of claim 6, wherein the plurality of gate electrode structures are interconnected with a plurality of gate busbars.

8. The apparatus of any one of the preceding claims, wherein the semiconductor substrate comprises a n-type dopant, and when a gate voltage of the gate electrode is set to a voltage higher than a barrier voltage of the metal layer, a reverse bias current flows from an ohmic contact of the semiconductor substrate to the metal layer.

9. The apparatus of any one of the preceding claims, wherein the gate electrode is insulated from the metal layer with a material comprising a dielectric constant less than 3.0, a material comprising a breakdown strength greater than 10 kilovolt per centimeter (kV/cm), or an air gap.

10. The apparatus of any one of the preceding claims, wherein the gate electrode is insulated from the semiconductor substrate with a material comprising a dielectric constant greater than 3.5.

11. A method comprising:

    applying a reverse bias voltage to a Schottky barrier,

    wherein the Schottky barrier comprises a semiconductor substrate at a first voltage and a metal layer at a second voltage,
    wherein the metal layer partially covers the semiconductor substrate,
    wherein the metal layer comprises an edge at a periphery of the metal layer, and
    wherein the edge is located on the semiconductor substrate; and

applying a third voltage to a gate electrode, wherein the gate electrode is adjacent to and insulated from the edge and the semiconductor substrate, thereby increasing a flow of current in a reverse bias direction.

12. The method of claim 11, further comprising a first insulating layer between the gate electrode and the metal layer, and wherein the first insulating layer comprises a material with a breakdown strength greater than 10 kilovolt per centimeter (kV/cm), a material with a dielectric constant less than 3.0, or an air gap.

13. The method of any one of claims 11 to 12, further comprising a second insulating layer between the gate electrode and the semiconductor substrate, wherein the second insulating layer comprises a material with a dielectric constant greater than 3.5 and a breakdown strength greater than 10 kV/cm.

14. The method of any one of claims 11 to 13, wherein the metal layer forms one or more comb-shaped structures configured to increase a length of the edge for a given area of the semiconductor substrate.

15. The method of any one of claims 11 to 14, wherein the metal layer comprises segments configured to increase a length of the edge for a given area of the semiconductor substrate, and wherein the segments have a shape comprising at least one of a line segment, a curved segment, a circular structure, or a perforation.

100

103

T1

T2

110

102    102    102

112    112

Semiconductor Substrate 101

104

T3    112    101A

**FIG. 1A**

110

T1    102    113    111

101

Semiconductor Substrate    112

**FIG. 1B**

200

Apply reverse bias voltage

201

202

Apply electrode (gate) voltage

203A

Increase
Charge
Density

203B

Change
Barrier
Energy

203C

Change
depletion
region

Increase
Tunnelling
Probability

203D

Increase
Thermionic
Emission

203E

Increase
Therm.-field
Emission

203C

204

Reverse bias current flow

FIG. 2

FIG. 3A

FIG. 3B

FIG. 3C

FIG. 3D

FIG. 3E

FIG. 4

500

T3

502

501

504A

T2

Metal

504

504B

503

T1

FIG. 5A

510

T3

512

511

514

T2

515

513 513 513 513 513 513 513 513 513 513 513

T1

FIG. 5B

600

T2

604B

T1

Metal 603

604A

Metal 603

Semiconductor 601

T3

602

FIG. 6A

610

T2

614A

Metal 613

614C

Metal 613

614B

T1

Semiconductor 611

612

T3

FIG. 6B

620

T1     T2

| 624A | | 624A |

| 624B | | 624B |

623

625

Semiconductor 621

622

T3

FIG. 6C

630

T2

634A

634B     634C

636

633

T1

635

Semiconductor 631

632

T3

FIG. 6D

640

T2     T1     T2

644A

644B

Metal 643

644C

Semiconductor 641

642

T3

FIG. 6E

650

654C

656

653

T1

655

T2

Semiconductor 651

654A

652

654B

T3

FIG. 6F

700

FIG. 7A

702
702C
702A
702B

X = 30.1 um
Y = 30.1 um
Ang. = 90 deg

FIG. 7B

FIG. 7C

FIG. 7D

FIG. 7E

800

```
┌─────────────────────────┐
│      Prepare wafer       │ ◄──── 801
└─────────────────────────┘
            │
            ▼
┌─────────────────────────┐
│     Photolithography     │ ◄──── 802
└─────────────────────────┘
            │
            ▼
┌─────────────────────────┐
│      Etch gate metal     │ ◄──── 803
└─────────────────────────┘
            │
            ▼
┌─────────────────────────┐
│        Etch high K       │ ◄──── 804
└─────────────────────────┘
            │
            ▼
┌─────────────────────────┐
│      Undercut high K     │ ◄──── 805
└─────────────────────────┘
            │
            ▼
┌─────────────────────────┐
│    Deposit barrier metal │ ◄──── 806
└─────────────────────────┘
            │
            ▼
┌─────────────────────────┐
│      Remove top layers   │ ◄──── 807
└─────────────────────────┘
```

FIG. 8A

810

| Gate metal 811 |
| High K dielectric 812 |
| Low doped epitaxial layer 813 |
| High doped semiconductor 814 |
| Ohmic contact 815 |

FIG. 8B

820

| Photoresist 821 | | Photoresist 821 |
| Top metal 811 | | |
| High K dielectric 812 | | |
| Low doped epitaxial layer 813 | | |
| High doped semiconductor 814 | | |
| Ohmic contact 815 | | |

FIG. 8C

830 ⤸

| Photoresist 821 | | Photoresist 821 |
| Top metal 831 | Etched 832 | Top metal 831 |

High K dielectric 812

Low doped epitaxial layer 813

High doped semiconductor 814

Ohmic contact 815

## FIG. 8D

840 ⤸

| Photoresist 821 | | Photoresist 821 |
| Top metal 831 | | Top metal 831 |
| High K dielectric 842 | Etched 841 | High K dielectric 842 |

Low doped epitaxial layer 813

High doped semiconductor 814

Ohmic contact 815

## FIG. 8E

850 ⟍

| Photoresist 821 | | Photoresist 821 |
|---|---|---|
| Top metal 831 | | Top metal 831 |
| High K dielectric 852 | Etched 851 | High K dielectric 852 |
| Low doped epitaxial layer 813 | | |
| High doped semiconductor 814 | | |
| Ohmic contact 815 | | |

FIG. 8F

860 ⟍

| 861B | | 861B | } Remove 862 |
|---|---|---|---|
| Photoresist 821 | | Photoresist 821 | |
| Top metal 831 | | Top metal 831 | |
| High K dielectric 842 | 861A | High K dielectric 842 | |
| Low doped epitaxial layer 813 | | | |
| High doped semiconductor 814 | | | |
| Ohmic contact 815 | | | |

FIG. 8G

870 ⭢

| 871B | 871B | } Remove |
| Photoresist 821 | Photoresist 821 | 872 |
| Gate metal 831 | Gate metal 831 | |

| High K dielectric 852 | 871A | High K dielectric 852 |

| Low doped epitaxial layer 813 |

| High doped semiconductor 814 |

| Ohmic contact 815 |

FIG. 8H

FIG. 9

1000

```
Prepare wafer          ← 1001
      ↓
Photolithography       ← 1002
      ↓
Etch barrier metal     ← 1003
      ↓
Deposit high K dielectric  ← 1004
      ↓
Deposit gate metal     ← 1005
      ↓
Remove top layers      ← 1006
```

FIG. 10A

1010 ⟶

| Barrier metal 1011 |
| Low doped epitaxial layer 1012 |
| High doped semiconductor 1013 |
| Ohmic contact 1014 |

**FIG. 10B**

1020 ⟶

| Photoresist 1021 | Photoresist 1021 |
| Barrier metal 1011 ||
| Low doped epitaxial layer 1012 ||
| High doped semiconductor 1013 ||
| Ohmic contact 1014 ||

**FIG. 10C**

Photoresist 1021

1030

Metal 1031 | Etched 1032 | Metal 1031

Low doped epitaxial layer 1012

High doped semiconductor 1013

Ohmic contact 1014

FIG. 10D

High-K material 1041

1040

1021 | 1021

Metal 1031 | Metal 1031

Low doped epitaxial layer 1012

High doped semiconductor 1013

Ohmic contact 1014

FIG. 10E

Gate metal 1051

Remove

1041

1052

1021

1021

Metal 1031

Metal 1031

1050

Low doped epitaxial layer 1012

High doped semiconductor 1013

Ohmic contact 1014

FIG. 10F

1022

Prepare wafer — 1001

↓

Photolithography — 1002

↓

Etch metal and Epi layer — 1023

↓

Deposit high K dielectric — 1004

↓

Deposit gate metal — 1005

↓

Photolithography — 1024

↓

Etch to gate metal — 1025

↓

Remove top layers — 1026

FIG. 10G

Photoresist 1021

1060 ➔

Metal 1061 · Etched 1063 · Metal 1061

1062 1062

High doped semiconductor 1013

Ohmic contact 1014

FIG. 10H

High-K material 1071

1070 ➔

1021 1021

Metal 1061 Metal 1061

1062 1062

High doped semiconductor 1013

Ohmic contact 1014

FIG. 10I

Gate metal 1081

1080

| 1071 | | 1071 |
| 1021 | | 1021 |
| Metal 1061 | | Metal 1061 |
| 1062 | | 1062 |

High doped semiconductor 1013

Ohmic contact 1014

FIG. 10J

1090

| 1091 | | 1091 |
| 1081 | | 1081 |
| 1071 | | 1071 |
| 1021 | Etched 1092 | 1021 |
| Metal 1061 | | Metal 1061 |
| 1062 | | 1062 |

Remove 1093

1081

1071

High doped semiconductor 1013

Ohmic contact 1014

FIG. 10K

1100 —

Prepare wafer — 1101

↓

Photolithography — 1102

↓

Etch high K — 1103

↓

Deposit metal layer — 1104

↓

Photolithography — 1105

↓

Etch metal — 1106

↓

Remove mask — 1107

FIG. 11A

1110

| High K dielectric <u>1111</u> |
| Low doped epitaxial layer <u>1112</u> |
| High doped semiconductor <u>1113</u> |
| Ohmic contact <u>1114</u> |

**FIG. 11B**

1120

| <u>Mask 1121</u> |
| High K dielectric <u>1111</u> |
| Low doped epitaxial layer <u>1112</u> |
| High doped semiconductor <u>1113</u> |
| Ohmic contact <u>1114</u> |

**FIG. 11C**

1130⤳

| Etched 1132 | Mask 1121 | Etched 1132 |
| --- | --- | --- |
| | 1131 | |

Low doped epitaxial layer 1112

High doped semiconductor 1113

Ohmic contact 1114

**FIG. 11D**

1140⤳

1141

| 1141 | 1111 | 1141 |
| --- | --- | --- |

Low doped epitaxial layer 1112

High doped semiconductor 1113

Ohmic contact 1114

**FIG. 11E**

FIG. 11F

FIG. 11G

1170

| 1141 |
|:---:|

| 1162 | 1111 | 1162 |

Low doped epitaxial layer 1112

High doped semiconductor 1113

Ohmic contact 1114

FIG. 11H

1200

```
┌─────────────────────┐
│    Prepare wafer     │ ←── 1201
└─────────────────────┘
           │
           ▼
┌─────────────────────┐
│   Photolithography   │ ←── 1202
└─────────────────────┘
           │
           ▼
┌─────────────────────┐
│    Etch epi layer    │ ←── 1203
└─────────────────────┘
           │
           ▼
┌─────────────────────┐
│ Deposit dielectric and│ ←── 1204
│     metal layers     │
└─────────────────────┘
           │
           ▼
┌─────────────────────┐
│    Grind or liftoff  │ ←── 1205
└─────────────────────┘
           │
           ▼
┌─────────────────────┐
│   Photolithography   │ ←── 1206
└─────────────────────┘
           │
           ▼
┌─────────────────────┐
│  Deposit metal layer │ ←── 1207
└─────────────────────┘
           │
           ▼
┌─────────────────────┐
│ Liftoff or grind mask│ ←── 1208
└─────────────────────┘
```

FIG. 12A

1210

| Low doped epitaxial layer 1212 |
| High doped semiconductor 1213 |
| Ohmic contact 1214 |

FIG. 12B

1220

| Mask 1221 | | Mask 1221 |
| Low doped epitaxial layer 1212 |
| High doped semiconductor 1213 |
| Ohmic contact 1214 |

FIG. 12C

1230

| Mask 1221 | | Mask 1221 |
| 1232 | Etched 1231 | 1232 |
| High doped semiconductor 1213 |
| Ohmic contact 1214 |

FIG. 12D

EP 4 113 625 A1

FIG. 12E

FIG. 12F

FIG. 12G

63

Europäisches
Patentamt

European
Patent Office

Office européen
des brevets

# EUROPEAN SEARCH REPORT

Application Number

EP 22 18 1437

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | JP H09 8300 A (TOSHIBA CORP) 10 January 1997 (1997-01-10) * the whole document * ----- | 1-15 | INV. H01L29/76 H01L21/334 H01L29/423 |
| X,P | US 2022/029012 A1 (INOKUCHI TOMOAKI [JP] ET AL) 27 January 2022 (2022-01-27) * the whole document * ----- | 1,11 | ADD. H01L29/47 |

**TECHNICAL FIELDS SEARCHED (IPC)**

H01L

The present search report has been drawn up for all claims

| Place of search | Date of completion of the search | Examiner |
|---|---|---|
| Munich | 14 November 2022 | Götz, Andreas |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 22 18 1437

This annex lists the patent family members relating to the patent documents cited in  the above-mentioned European search report.
The members are as contained in the European Patent Office EDP file on
The European Patent Office is in no way liable for these particulars which are merely given for the purpose of information.

14-11-2022

| Patent document cited in search report | | Publication date | Patent family member(s) | | Publication date |
|---|---|---|---|---|---|
| JP H098300 | A | 10-01-1997 | JP | 3329642 B2 | 30-09-2002 |
| | | | JP | H098300 A | 10-01-1997 |
| US 2022029012 | A1 | 27-01-2022 | NONE | | |

EPO FORM P0459

For more details about this annex : see Official Journal of the European Patent Office, No. 12/82

**REFERENCES CITED IN THE DESCRIPTION**

**Patent documents cited in the description**

- US 63216073

- US 63292831